# EUROPEAN PATENT APPLICATION

(11) **EP 2 677 232 A1**
(43) Date of publication of application: **25.12.2013**
(21) Application number: 12747074.8
(22) Date of filing: 10.02.2012
(51) Int. Cl.: F21S 8/10, B60Q 1/04, F21S 8/12, F21V 19/00, H01L 33/50, F21W 101/10, F21W 101/12, F21Y 101/02

(54) **LIGHT EMITTING MODULE AND LIGHTING DEVICE FOR VEHICLE**

(30) Priority: 15.02.2011 JP 2011030123
(71) Applicant: Koito Manufacturing Co., Ltd., Tokyo 108-8711 (JP)
(72) Inventor: TSUTSUMI, Yasuaki, Shizuoka-shi, Shizuoka 424-8764 (JP); MIZUNO, Masanobu, Shizuoka-shi, Shizuoka 424-8764 (JP); KOMATSU, Motohiro, Shizuoka-shi, Shizuoka 424-8764 (JP)
(74) Representative: Algemeen Octrooi- en Merkenbureau B.V.
(86) International application number: PCT/JP2012/000904
(87) International publication number: WO 2012/111292

(57) **Abstract**

A light-emitting module 50 is provided with a substrate 54, a plurality of semiconductor light-emitting elements 52a through 52d mounted on the substrate 54 and arranged in a matrix, a fluorescent substance layer 58 provided such that the fluorescent substance layer 58 faces respective light-emitting surfaces 56a through 56d of the semiconductor light-emitting elements, and light-shielding portions 60a through 60d provided such that the light-shielding portions surround the perimeter of respective light-emitting surfaces of at least some light-emitting elements among the plurality of semiconductor light-emitting elements.

## Description

### [TECHNICAL FIELD]

The present invention relates to a light-emitting module provided with a light-emitting element such as a light-emitting diode.

### [Background Art]

When lighting a wide range of a road surface by an automotive lamp at night, a lamp unit that forms a light distribution pattern for high beam is often used. Meanwhile, since such a light distribution pattern for high beam may cast glare onto oncoming vehicles and leading vehicles, further improvement has been required.

For example, automotive lamps have been devised that extend an irradiated range by swiveling a lamp unit that forms a light distribution pattern for low beam from side to side (see Patent Document 1). However, since such a lamp requires a mechanism component for the swiveling, a device becomes complicated and increased in size, and it becomes difficult to switch light distribution instantly.

Meanwhile, in recent years, an automotive lamp is being developed that uses as a white light-emitting diode (hereinafter, referred to as LED (Light Emitting Diode), whose performance has been improved remarkably, as a light source. For example, light sources have been devised in which a plurality of white LEDs are arranged in a matrix array (see Patent Document 2).

[Patent Document 1] Japanese Patent Application (Laid-Open) No. 2007-30739
[Patent Document 2] Japanese Patent Application (Laid-Open) No. 2009-134965

### [DISCLOSURE OF THE INVENTION]

### [PROBLEM TO BE SOLVED BY THE INVENTION]

In this background, a purpose of the present invention is to provide a light-emitting module designed to be applied to lighting or lamps.

### [MEANS TO SOLVE THE PROBLEM]

A light-emitting module according to one embodiment of the present invention includes: a substrate; a plurality of light-emitting elements mounted on the substrate and arranged in a matrix; a fluorescent member provided such that the fluorescent member faces respective light-emitting surfaces of the light-emitting elements; and a light-shielding portion provided such that the light-shielding portion surrounds the perimeter of respective light-emitting surfaces of at least some light-emitting elements among the plurality of light-emitting elements.

According to this embodiment, light leakage between the light-emitting elements can be prevented by the light-shielding portion.

The plurality of light-emitting elements may include a first light-emitting element having relatively high luminance when turned on and a second light-emitting element having relatively low luminance when turned on. The light-shielding portion may be mainly provided between the first light-emitting element and a light-emitting element adjacent to the first light-emitting element. With this, light leakage from the first light-emitting element can be prevented, and the light-shielding portion used for the entire light-emitting module can be reduced, thus achieving a cost reduction.

The light-emitting elements may be flip-chip type elements. With this, a region for connecting a wiring to a substrate is not necessary, and a space between the light-emitting elements can be reduced, for example, in comparison to light-emitting elements to be mounted on a substrate by wire bonding. As a result, the generation of a shadow created in a light distribution pattern, which is caused by spaces between adjacent light-emitting elements, can be prevented.

The fluorescent member may be a plate-like fluorescent substance. With this, the processing of a fluorescent substance is facilitated. In particular, various sorts of surface processing for improving the brightness becomes possible.

The thermal expansion coefficient of the substrate may be in a range of ± 5 ppm/°C of the thermal expansion coefficient of the light-emitting elements. With this, a decrease in connection reliability created by repeating temperature changes by turning on or off the light-emitting elements can be prevented.

The light-emitting module may further include a lens configured to project a light-source image, which is created by light emitted from the light-emitting elements and the fluorescent member, on a virtual vertical screen provided in front in an irradiation direction. The lens is directly connected to the light-emitting elements or the fluorescent member. With this, light from the light-emitting elements or light passed through the fluorescent member becomes less likely to be absorbed or reflected at an interface with the lens, and luminous flux emitted from the light-emitting module is improved.

Another embodiment of the present invention relates to an automotive lamp. The automotive lamp includes; the light-emitting module; and a control circuit configured to control the turning on and off of the light-emitting module, wherein, if the control circuit detects a condition where a vehicle provided with the automotive lamp is stopped, the control circuit controls the turned-on or turned-off condition of the light-emitting module so as to enter a vehicle stop mode where the power consumption is smaller than that during an irradiation mode used when the vehicle is running.

According to this embodiment, the power saving of an automotive lamp can be achieved without requiring an operation by a driver.

Optional combinations of the aforementioned constituting elements, and implementations of the invention in the form of methods, apparatuses, and systems may also be practiced as additional modes of the present invention.

### [ADVANTAGE OF THE INVENTION]

According to the present invention, a light-emitting module can be provided that is designed to be applied to lighting or lamps.

### [BRIEF DESCRIPTION OF THE DRAWINGS]

Fig. 1 is a schematic cross-sectional view of an automotive lamp according to an embodiment of the present invention;
Fig. 2 is a perspective view illustrating an essential portion of a lamp unit shown in Fig. 1;
Fig. 3 is a front view of a light-emitting module shown in Fig. 1;
Fig. 4 is a view illustrating an example of a light distribution pattern formed by an automotive lamp according to the embodiment of the present invention;
Fig. 5 is a schematic sectional view illustrating an example of a light-emitting module according to the embodiment of the present invention;
Fig. 6A is a schematic diagram for explaining the structure of an LED chip that is suitable for the light-emitting module according to the embodiment of the present invention, and Fig. 6B is a schematic diagram illustrating the structure of an LED chip according to a comparative example;
Fig. 7 is a schematic diagram illustrating a condition where LED chips of different sizes are arranged in a matrix;
Fig. 8 is a schematic diagram illustrating a condition where LED chips of different shapes are arranged in a matrix;
Fig. 9A is a schematic diagram illustrating a state where electrode portions of LED chips are arranged in a longitudinal direction; and Fig. 9B is a schematic diagram illustrating a state where electrode portions of LED chips are arranged in a traverse direction;
Fig. 10 is a schematic diagram illustrating a condition where intervals between LED chips are changed by location;
Fig. 11 is a schematic diagram illustrating a condition where a plurality of types of LED chips of different emission wavelengths are arranged;
Fig. 12 is a schematic diagram illustrating a condition where a plurality of LED chips formed on a single epitaxial substrate are mounted on a mounting substrate;
Fig. 13A is a schematic diagram illustrating a condition where, of LED chips arranged in a matrix, LED chips of some lines (rows) are displaced, and Fig. 13B is a schematic diagram illustrating a condition where a plurality of rectangular LED chips are arranged at an angle and in a matrix;
Fig. 14 is a schematic diagram illustrating a condition where a light-shielding frame is provided only around some LED chips;
Fig. 15A is a schematic sectional view of a light-emitting module in which a light-shielding film is formed on a part of the side of a light-shielding frame, Fig. 15B is an enlarged view of a part of the light-shielding frame shown in Fig. 15A, and Fig. 15C is a view illustrating an exemplary variation of the part of the light-shielding frame shown in Fig. 15B;
Fig. 16 is a schematic diagram illustrating a condition where the thickness of a part of a light-shielding frame is reduced;
Fig. 17 is a schematic diagram illustrating a condition where the area of a region in which a light-shielding frame surrounds LED chips is changed according to a chip;
Fig. 18 is a schematic sectional view of a light-emitting module in which a light-shielding film is formed on the side of a fluorescent substance;
Fig. 19 is a schematic diagram illustrating a condition where a reflective film is formed on a part of a light-shielding frame;
Fig. 20 is a schematic sectional view of a light-emitting module in which an ultraviolet light-emitting chip is used as an LED chip;
Fig. 21 is a schematic diagram illustrating a light-emitting module in which the shape of a region partitioned by a frame is hexagonal;
Fig. 22 is a schematic diagram illustrating a condition where the size of a fluorescent substance layer that is partitioned varies by location;
Figs. 23A to 23G are schematic sectional views for explaining the shape of a fluorescent substance layer;
Figs. 24A to 24F are schematic sectional views for explaining the arrangement of a fluorescent substance layer in a light-emitting module;
Fig. 25A is a schematic diagram illustrating a condition where a fluorescent substance layer is created for each section by a potting method, and Figs. 25B to 25D are schematic diagrams illustrating a condition where fluorescent substance layers are created all at once by a printing method;
Fig. 26 is a schematic sectional view illustrating an example of a mounting substrate;
Fig. 27 is a schematic diagram illustrating a mounting substrate having a double-sided wiring;
Fig. 28A is a schematic sectional view of a light-emitting module according to comparative example 1, and Fig. 28B is a view illustrating a graph of a brightness distribution of the light-emitting module according to comparative example 1;
Fig. 29A is a schematic sectional view of a light-emitting module according to exemplary embodiment 1, and Fig. 29B is a view illustrating a graph of a brightness distribution of the light-emitting module according to exemplary embodiment 1;
Fig. 30A is a schematic sectional view of a light-emitting module according to exemplary embodiment 2, and Fig. 30B is a view illustrating a graph of a brightness distribution of the light-emitting module according to exemplary embodiment 2;
Fig. 31A is a schematic sectional view of a light-emitting module according to exemplary embodiment 3, and Fig. 31B is a view illustrating a graph of a brightness distribution of the light-emitting module according to exemplary embodiment 3;
Fig. 32A is a schematic sectional view of a light-emitting module according to exemplary embodiment 4, and Fig. 32B is a view illustrating a graph of a brightness distribution of the light-emitting module according to exemplary embodiment 4;
Fig. 33A is a schematic sectional view of a light-emitting module according to exemplary embodiment 5, and Fig. 33B is a view illustrating a graph of a brightness distribution of the light-emitting module according to exemplary embodiment 5;
Fig. 34A is a schematic sectional view of a light-emitting module according to exemplary embodiment 6, and Fig. 34B is a view illustrating a graph of a brightness distribution of the light-emitting module according to exemplary embodiment 6;
Fig. 35A is a schematic sectional view of a light-emitting module according to exemplary embodiment 7, and Fig. 35B is a view illustrating a graph of a brightness distribution of the light-emitting module according to exemplary embodiment 7; and
Fig. 36A is a schematic sectional view of a light-emitting module according to exemplary embodiment 8, and Fig. 36B is a view illustrating a graph of a brightness distribution of the light-emitting module according to exemplary embodiment 8.

### [BEST MODE FOR CARRYING OUT THE INVENTION]

Hereinafter, an example embodiment for carrying out the present invention will be described in detail with reference to the accompanying drawing. In the explanation of the figures, like numerals represent like constituting elements, and duplicative explanations will be omitted appropriately.

A light-emitting module according to an embodiment of the present invention is applicable to all kinds of lighting or lamps including automotive lamps. In particular, the light-emitting module according to an embodiment of the present invention is suitable for lighting or lamps that achieves a plurality of light distribution patterns by controlling the brightness of some or all of a plurality of light-emitting elements provided in a light-emitting module.

### (Automotive Lamp)

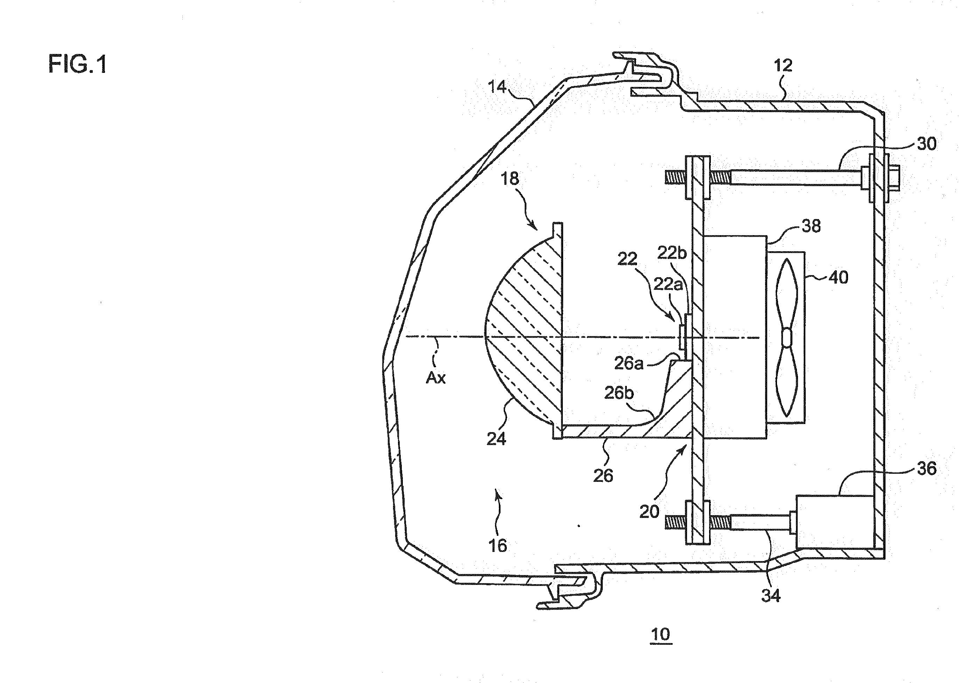

An explanation is first given of an automotive lamp as an example of a lamp to which a light-emitting module according to an embodiment of the present invention is applied. Fig. 1 is a schematic cross-sectional view of an automotive lamp according to an embodiment of the present invention.

An automotive lamp 10 is provided with a lamp body 12, a transparent cover 14, a lamp unit 18 housed in a lamp chamber 16 formed by the lamp body 12 and the transparent cover 14, and a bracket 20 serving as a support member that supports the lamp unit 18 in the lamp chamber 16. The lamp unit 18 is a projector-type lamp unit of a direct irradiation method and is provided with a light-emitting module 22 provided with a plurality of semiconductor light-emitting elements, a projection lens 24, and a connecting member 26 for connecting the projection lens 24 to the bracket 20.

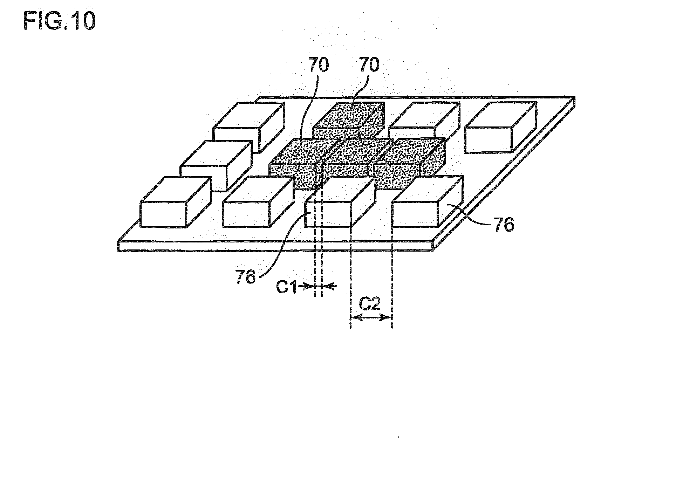

The light-emitting module 22 is provided with an LED 22a, which serves as a semiconductor light-emitting element, and a thermally-conductive insulating substrate 22b, which is formed by ceramics or the like. The light-emitting module 22 is placed on the bracket 20 such that the illumination axis of the light-emitting module 22 is directed in a forward direction of a vehicle, which is approximately parallel to an irradiation direction (a leftward direction in Fig. 10) of the lamp unit 18.

The connecting member 26 has a planar part 26a and a curved part 26b. The planar part 26a is disposed approximately horizontally, and the curved part 26b is in an area in front of the planar part 26a. The shape of the curved part 26b is formed such that light emitted from the light-emitting module 22 is not reflected.

The projection lens 24 is a plano-convex aspheric lens, having a convex front surface and a plane rear surface, which projects light emitted from the light-emitting module 22 toward a front area of the lamp. The projection lens 24 is disposed on a light axis Ax extending in frontward and rearward directions of the vehicle and is fixed to a tip end part of the connecting member 26 on the front side of the vehicle. Near a rear focal point of the projection lens 24, the LED chip 22a of the light-emitting module 22 is placed. Light emitted from the light-emitting module 22 directly enters the projection lens 24. The light that has entered the projection lens 24 is collected by the projection lens 24 and radiated in the forward direction as approximately parallel light beams.

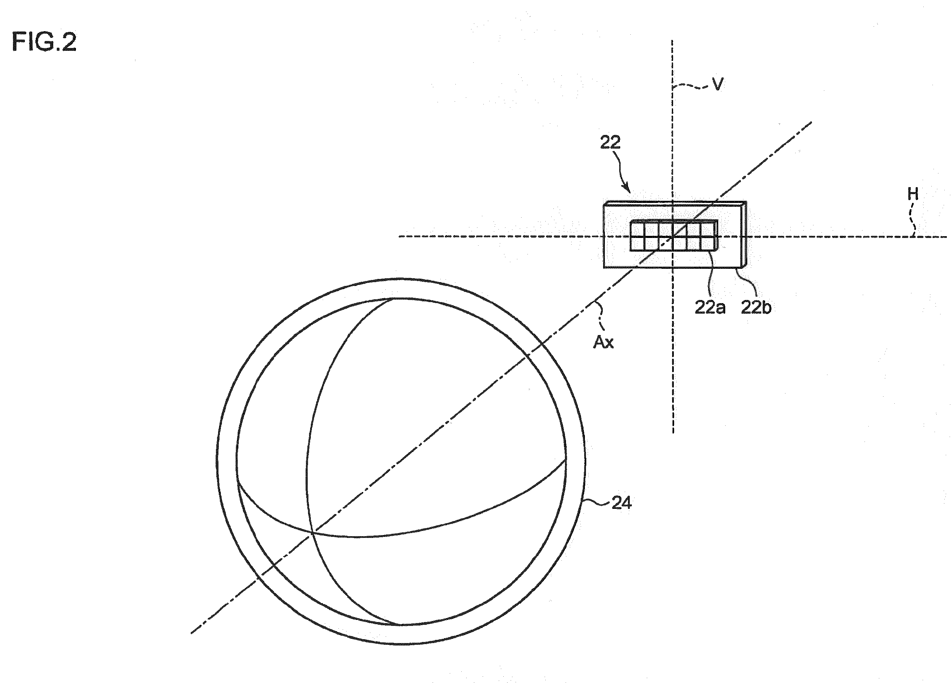

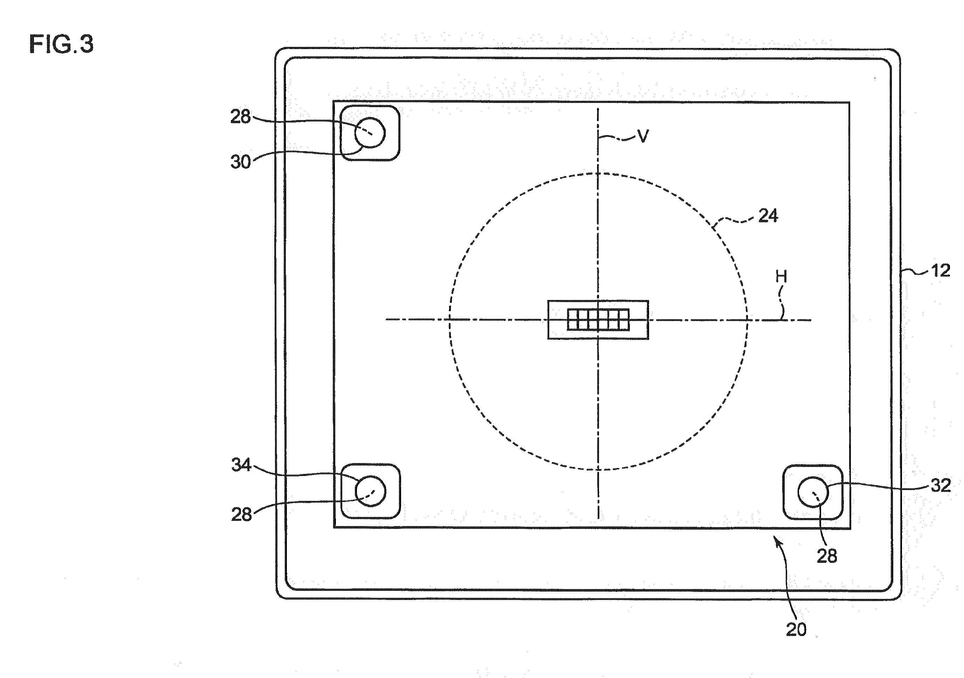

Fig. 2 is a perspective view illustrating an essential portion of the lamp unit 18 shown in Fig. 1. Fig. 3 is a front view of the light-emitting module 22 shown in Fig. 1. As shown in Figs. 2 and 3, the light-emitting module 22 has a plurality of LED chips 22a. In the light-emitting module 22 according to the present embodiment, the total of twelve LED chips 22a are arranged in matrix on the thermally-conductive insulating substrate 22b, six chips 22a being arranged in a horizontal direction H and two chips 22a being arranged in a vertical direction V.

As shown in Figs. 1 and 3, screw holes 28 are formed at predetermined edge portions (three corner portions) of a square bracket 20. In the screw holes 28, either one end of an aiming screw 30, either one end of an aiming screw 32, and either one end of a leveling shaft 34 are fixed, respectively. The respective other ends of the aiming screws 30 and 32 and the leveling shaft 34 are fixed in screw holes (not shown) of the lamp body 12. With this, the bracket 20 is attached to the lamp body 12 in a condition where the bracket 20 is spaced forwardly apart from the rear surface of the lamp body 12. The automotive lamp 10 is configured such that the light axis of the lamp unit 18 can be adjusted in the horizontal direction or the vertical direction by the aiming screws 30 and 32, the leveling shaft 34, and a leveling actuator 36.

Further, a heat radiating fin 38 is provided on the rear side surface of the bracket 20. Further, between the heat radiating fin 38 and the lamp body 12, a fan 40 is provided that sends air toward the heat radiating fin 38 so as to cool the heat radiating fin 38.

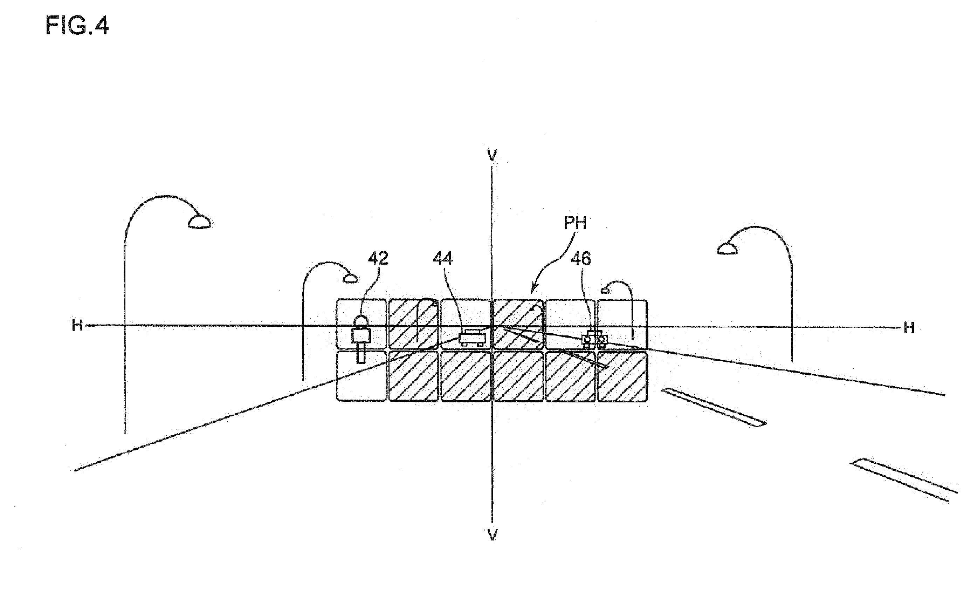

Fig. 4 is a view illustrating an example of a light distribution pattern formed by the automotive lamp 10 according to the embodiment of the present invention. The automotive lamp 10 shown in Fig. 1 is capable of forming a light distribution pattern PH in which a part of a region in front of a vehicle is not irradiated, as shown in Fig. 4, by turning off some LED chips 22a of the light-emitting module 22. Twelve rectangular regions shown in Fig. 4 correspond to regions irradiated by respective LED chips, and regions shown with diagonal lines indicate a condition where light is being radiated.

Therefore, the automotive lamp 10 is capable of preventing glare casted onto a pedestrian 42, a leading vehicle 44, and an oncoming vehicle 46 by turning off respective LED chips that correspond to regions in which the pedestrian 42, the leading vehicle 44, and the oncoming vehicle 46 exist.

### (Light-Emitting Module)

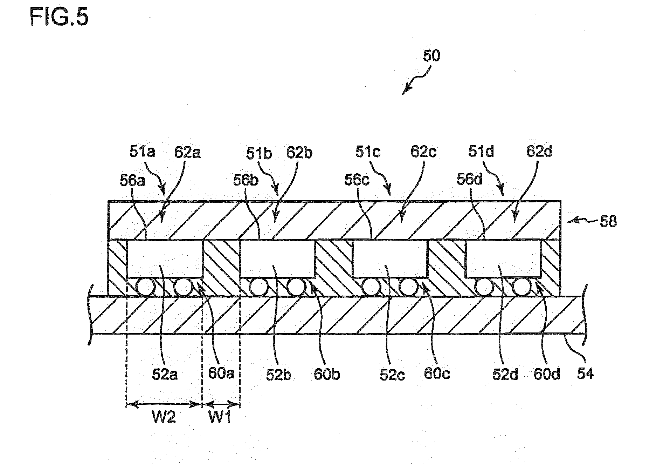

An explanation will be now given of a preferred example of the light-emitting module. Fig. 5 is a schematic sectional view illustrating an example of the light-emitting module according to the embodiment of the present invention. As shown in Fig. 5, the light-emitting module 50 according to the embodiment of the present invention is provided with a first light-emitting unit 51a through a fourth light-emitting unit 51d. The first light-emitting unit 51a is provided with a semiconductor light-emitting element 52a. The second light-emitting unit 51b is provided with a semiconductor light-emitting element 52b. The third light-emitting unit 51c is provided with a semiconductor light-emitting element 52c. The fourth light-emitting unit 51d is provided with a semiconductor light-emitting element 52d. The semiconductor light-emitting elements 52a through 52d, which are arranged in a matrix, are mounted on a substrate 54.

Further, a fluorescent substance layer 58 is provided so as to face light-emitting surfaces 56a through 56d of the respective semiconductor light-emitting elements 52a through 52d. The fluorescent substance layer 58 functions as an optical wavelength conversion member that converts the wavelength of light emitted by the semiconductor light-emitting elements 52a through 52d, which are facing the fluorescent substance layer 58, so as to emit the light.
In the case where light of a color or a wavelength that is necessary can be obtained without using a fluorescent substance layer 58, the light-emitting module 50 may not be provided with a fluorescent substance layer 58.

An interval W1 between light-emitting units is preferably smaller than a width W2 of a light-emitting unit. The interval W1 needs to be designed appropriately using experiments or previous findings while taking into consideration not to create a space between regions irradiated by the respective light-emitting units. When the light-emitting module is to be used in an automotive lamp (automotive headlamp apparatus), the interval W1 between light-emitting units is preferably set, for example, in a range of 10 to 500 µm. Each light-emitting unit can emit light of various colors by a combination of a semiconductor light-emitting element and a fluorescent substrate. For example, a light-emitting unit may be used that realizes white light by a combination of a semiconductor light-emitting element that emits blue light and a fluorescent substance that absorbs blue light and converts the light to yellow light. Alternatively, a light-emitting unit may be used that realizes white light by a combination of a semiconductor light-emitting element that emits ultraviolet light, a first fluorescent substance that absorbs ultraviolet light and converts the light to blue light, and a second fluorescent substance that absorbs ultraviolet light and converts the light to yellow light.

For the semiconductor light-emitting elements 52a through 52d, light-shielding portions 60a through 60d are provided so as to cover the sides and the lower surfaces of the respective semiconductor light-emitting elements. The light-shielding portions 60a through 60d may be separated from one another or may be formed in an integral manner as shown in Fig. 5. The light-shielding portions 60a through 60d may be provided to surround the perimeter of respective light-emitting surfaces of at least some semiconductor light-emitting elements among the plurality of semiconductor light-emitting elements.

In the light-emitting module 50 provided with such light-shielding portions 60a through 60d, even when a part of light of the semiconductor light-emitting element 52a is radiated toward the fluorescent substance layer 58 of a region 62b facing the light-emitting surface 56b of the adjacent semiconductor light-emitting element 52b, the part of the light is shielded by the light-shielding portion 60a. Also, even when a part of light of the semiconductor light-emitting element 52b is radiated toward the fluorescent substance layer 58 of regions 62a and 62c facing the light-emitting surfaces 56a and 56c of the adjacent semiconductor light-emitting elements 52a and 52c, respectively, the part of the light is shielded by the light-shielding portion 60b. Also, even when a part of light of the semiconductor light-emitting element 52c is radiated toward the fluorescent substance layer 58 of regions 62b and 62d facing the light-emitting surfaces 56b and 56d of the adjacent semiconductor light-emitting elements 52b and 52d, respectively, the part of the light is shielded by the light-shielding portion 60c. Also, even when a part of light of the semiconductor light-emitting element 52d is radiated toward the fluorescent substance layer 58 of the region 62c facing the light-emitting surface 56c of the adjacent semiconductor light-emitting element 52c, respectively, the part of the light is shielded by the light-shielding portion 60d.

As described, in the light-emitting module 50, the fluorescent substance layer 58 of a region facing a light-emitting surface of an adjacent semiconductor light-emitting element is prevented from lighting up due to light emitted from at least one semiconductor light-emitting element.
As a result, for example, when the light-emitting unit 51a is turned on and the light-emitting unit 51b adjacent to the light-emitting unit 51a is turned off, a region subjected to irradiation of the light-emitting unit 51b is prevented from being illuminated unintentionally. Also, even when a part of light of at least one semiconductor light-emitting element is radiated toward the irradiation region of an adjacent semiconductor light-emitting element, the part of the light is shielded by a light-shielding portion that covers the side surface of the semiconductor light-emitting element.

Therefore, when a semiconductor light-emitting element adjacent to a semiconductor light-emitting element being turned on is turned off, a region subjected to irradiation of a light-emitting unit that is provided with the semiconductor light-emitting element being turned off is prevented from being illuminated unintentionally. In other words, light leakage among the plurality of semiconductor light-emitting elements can be prevented. With this, the automotive lamp 10 is prevented from casting glare onto a passenger of a vehicle or a pedestrian in a region corresponding to a semiconductor light-emitting element that is turned off, when a light distribution pattern such as the one shown in Fig. 4 is formed.

The above described condition of being "arranged in a matrix" includes at least a case where a plurality of light-emitting elements are arranged in m × 1 (m is an integer of 2 or more), 1 × n (n is an integer of 2 or more), m × n (m and n are both integers of 2 or more). Two arrangement directions do not need to be always perpendicular to each other, and the light-emitting elements may be arranged in a range of a parallelogram or a trapezoid as a whole. The plurality of the light-emitting elements may not all be of a single type and may be of a combination of a plurality of types of light-emitting elements.

In an automotive lamp provided with a light source in which a plurality of conventional white LEDs are arranged in a matrix, there is a case where spaces between the plurality of white LEDs that are lined is projected on a light distribution pattern as a dark shadow. A driver driving a vehicle under such a situation may feel bothered by the shadow.

Accordingly, as a result of intensive study regarding such a point by the present inventors, it has been found that improvement can be realized by appropriately employing various measures and configurations described in the following in a light-emitting module according to the embodiment of the present invention. Also, prevention of both a shadow created on a light distribution pattern caused by spaces between semiconductor light-emitting elements or the like and light leakage to a region being turned off in the light-distribution pattern can be possible at a high level.

Examples of the measures described in the embodiment below are listed as follows:
(1) Structure, size, shape, etc. of a light-emitting element (LED chip)
(2) Material, shape, surface shape, etc., of a light-shielding portion
(3) Material, shape, surface processing, etc., of a fluorescent member
(4) Physical properties, shape, etc., of a mounting substrate
(5) Configuration, material, shape, etc., of a lens Control circuit In the following, an explanation is given mainly regarding devised configurations, and an explanation is omitted for other configurations (the other configurations are not shown).

### (1: LED Chip)

### [Chip Structure]

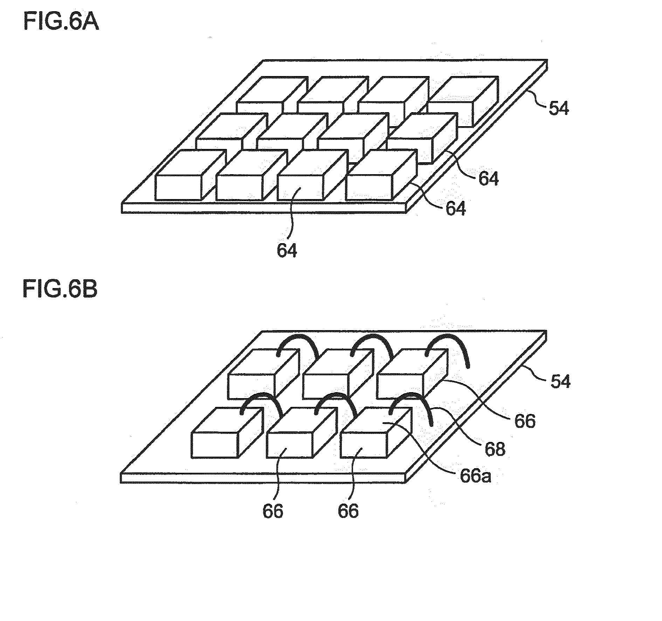

Fig. 6A is a schematic diagram for explaining the structure of an LED chip that is suitable for the light-emitting module according to the embodiment of the present invention, and Fig. 6B is a schematic diagram illustrating the structure of an LED chip according to a comparative example. When a plurality of LED chips are mounted on a substrate 54 in a matrix, an LED chip 64 of a face-down type (flip-chip type) (see Fig. 6A) or an LED chip 66 of a face-up type (see Fig. 6B) are considered to be employed.

However, as shown in Fig. 6B, in the case where LED chips 66 of a face-up type are employed, it is necessary to keep intervals between the chips for a wire bonding 68 that connects an upper surface 66a of a chip to the substrate 54. As a result, a shadow is likely to be created in a light distribution pattern. On the other hand, as shown in Fig. 6A, in the case of LED chips 64 of a flip-chip type, the chips are connected to the substrate via bump electrodes (not shown) at the respective lower surfaces of the chips, and no region for connecting a wire such as a wire bonding to the substrate is necessary. Thus, intervals between the LED chips can be narrowed. As a result, the generation of a shadow created in a light distribution pattern, which is caused by spaces between adjacent LED chips 64, can be prevented.

### [Chip Size]

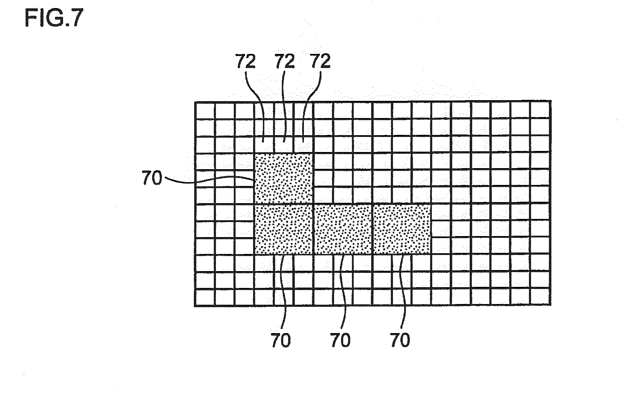

Fig. 7 is a schematic diagram illustrating a condition where LED chips of different sizes are arranged in a matrix. When a light-emitting module is applied in an automotive lamp, there is a region called a hot zone in a light distribution pattern of a headlamp that requires high luminance (e.g., 80000 cd or more). Accordingly, large-size (e.g., 1 mm × 1 mm) LED chips 70 that form a hot zone are arranged in the center part on the substrate. Meanwhile, small-size (e.g., 0.3 mm × 0.3 mm) LED chips 72 are arranged in the surrounding part thereof for a reduction of cost. With this, a light-emitting module can be realized with a cost reduction while allowing for the formation of a hot zone.

### [Chip Shape]

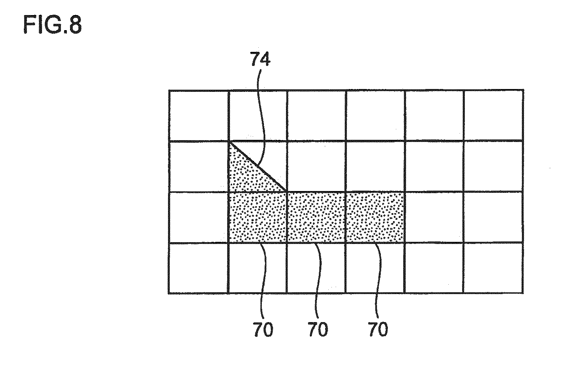

Fig. 8 is a schematic diagram illustrating a condition where LED chips of different shapes are arranged in a matrix. When a light-emitting module is applied in an automotive lamp, there is a case where the formation of a light distribution pattern for low beam having a diagonal cut-off line at a part of the upper portion of a light distribution pattern is required. Accordingly, a triangle LED chip 74 that forms a diagonal cut-off line at a part on the substrate is arranged. Meanwhile, regular LED chips 70 are arranged in the surrounding part thereof. The hypotenuse of the LED chip 74 preferable has a degree of about 10 to 60 with respect to the horizontal direction. More preferably, the hypotenuse of the LED chip 74 has a degree of 15, 30, 45, or the like.

### [Electrode Direction within Chip]

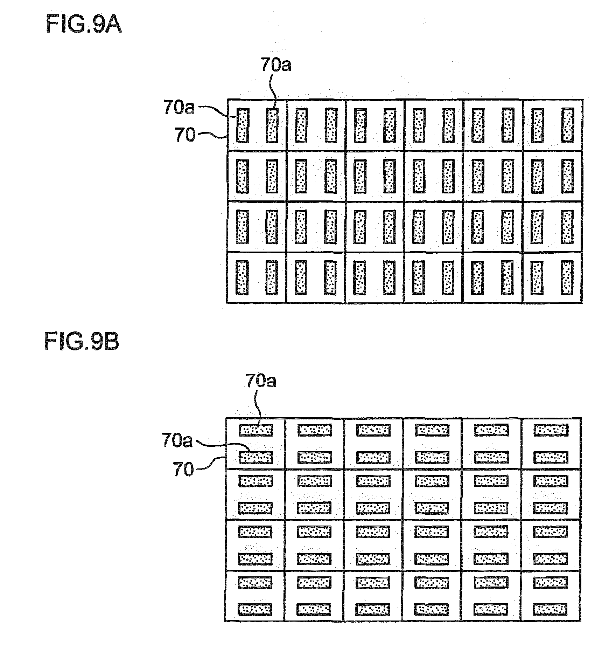

Fig. 9A is a schematic diagram illustrating a state where electrode portions of LED chips are arranged in a longitudinal direction, and Fig. 9B is a schematic diagram illustrating a state where electrode portions of LED chips are arranged in a traverse direction. In a LED chip 70, luminance is relatively low in electrode portions 70a, and luminance is relatively high in the center part between the electrodes 70a. Thus, luminance is uneven in a light-emitting surface. Also, since there are spaces between LED chips (about 100 to 300 µm), the luminance at the parts are obviously decreased, causing unevenness in luminance in the entire light-emitting module. Such unevenness in luminance often appears as a shadow (black line) in a light distribution pattern.

Thus, in order to prevent a black line in the horizontal direction, the LED chips 70 are arranged such that the electrode direction is in the longitudinal direction, as shown in Fig. 9A. On the other hand, in order to prevent a black line in the vertical direction, the LED chips 70 are arranged such that the electrode direction is in the traverse direction, as shown in Fig. 9B.

### [Interval between Chips]

Fig. 10 is a schematic diagram illustrating a condition where intervals between LED chips are changed by location. For example, at the center part where the LED chips 70 forming the above-described hot zone are arranged, intervals C1 between the chips are narrowed, and the density in the arrangement of the chips is high. Thus, the luminance of the hot zone in a light-distribution pattern can be increased. On the other hand, at the surrounding part where the LED chips 76 are arranged, intervals C2 between the chips are widened, and the density in the arrangement of the chips is low. Thus, the number of chips that irradiate the surrounding part of a light distribution pattern can be reduced, allowing for a reduction in cost for the entire light-emitting module.

### [Combination of a plurality of types of LED chips of Different Emission Wavelengths (Emission Colors)]

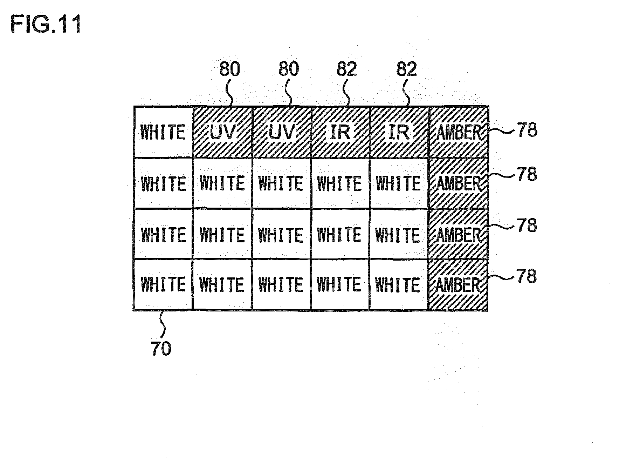

Fig. 11 is a schematic diagram illustrating a condition where a plurality of types of LED chips of different emission wavelengths are arranged. A light-emitting module shown in Fig. 11 is provided with LED chips 70 that emit white light and LED chips 78 that emit amber light. With this, an automotive lamp can be realized in which a headlight and a turn signal lamp are integrated. Also, by further integrating LED chips 80 that emit ultraviolet light (UV) and LED chips 82 that emit infrared light (IR), a light-source function for a night-vision camera can be added to the light-emitting module.

### [Separation of Epitaxial Layer]

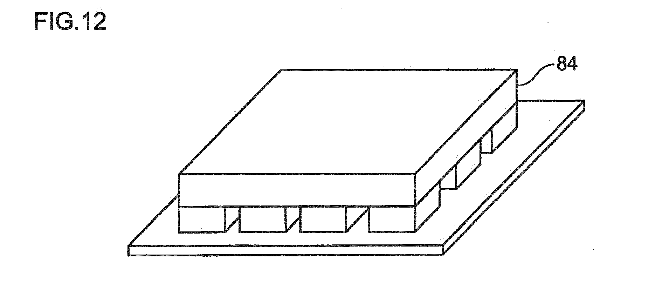

Fig. 12 is a schematic diagram illustrating a condition where a plurality of LED chips formed on a single epitaxial substrate are mounted on a mounting substrate. When separate LED chips are mounted in pairs on a substrate, spaces of about 100 µm are created between the chips due to the accuracy of a mounting apparatus. Thus, a plurality of LED chips are formed on a single epitaxial substrate 84, and portions of the epitaxial substrate between the chips are electrically cut (integral in a physical manner) by half-cut using a dicing blade so as to separate the epitaxial substrate for each individual LED chip. With this, spaces between the chips can be reduced, and light modulation can be individually performed on each LED chip.

### [Chip Arrangement]

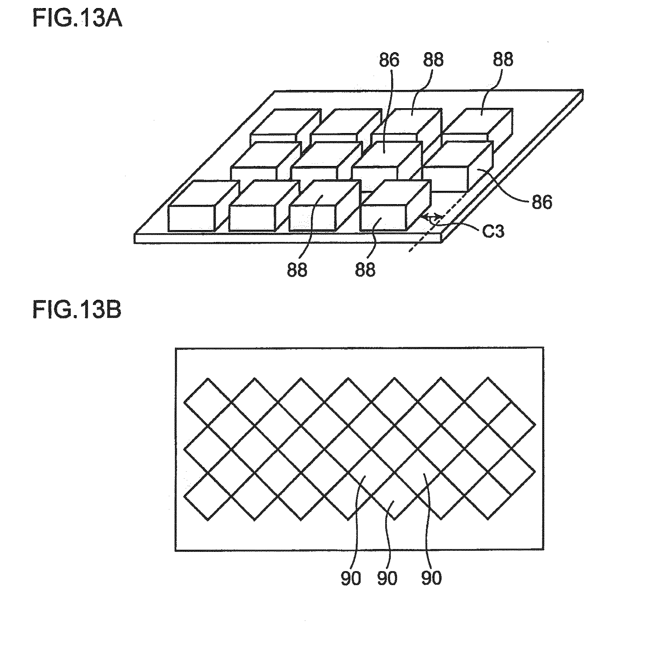

Fig. 13A is a schematic diagram illustrating a condition where, of LED chips arranged in a matrix, LED chips of some lines (rows) are displaced, and Fig. 13B is a schematic diagram illustrating a condition where a plurality of rectangular LED chips are arranged at an angle and in a matrix. As shown in Fig. 13A, LED chips 86 arranged in the center row are displaced in the right direction in the figure by a distance C3 with respect to LED chips 88 arranged in the front row or the back row. With this, spaces between the LED chips 86 arranged in the center row are displaced by the distance C3 with respect to respective spaces between the LED chips 88 arranged in the front row or the back row. Thus, a black line in the longitudinal direction (vertical direction) in a light distribution pattern that is formed by the light-emitting module becomes unnoticeable.

As shown in Fig. 13B, LED chips 90 are arranged in a matrix and in a diagonal manner so that spaces between adjacent LED chips 90 are diagonal. Therefore, black lines in the longitudinal direction (vertical direction) and in the traverse direction (horizontal direction) in a light distribution pattern formed by the light-emitting module become unnoticeable.

### (2: Light-Shielding Portion)

### [Partial Installation]

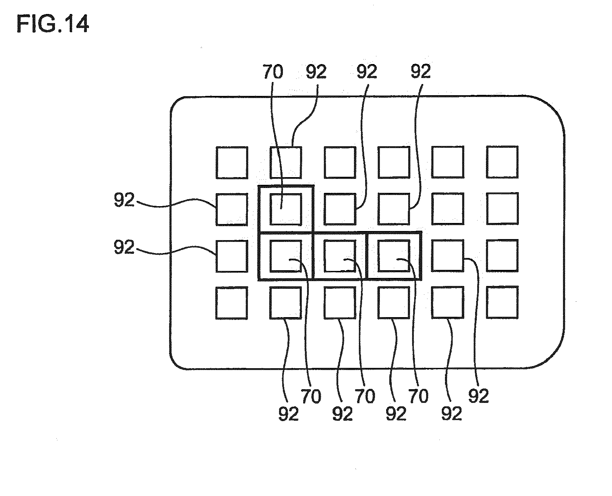

Fig. 14 is a schematic diagram illustrating a condition where a light-shielding frame is provided only around some LED chips. As described above, in order to prevent the leakage of light from an adjacent LED chip, it is preferred to provide a light-shielding frame such that the light-shielding frame surrounds the perimeter of a light-emitting surface. However, if spaces between LED chips are widened too much, a dark shadow will be projected on a part of a light distribution pattern. Thus, the spaces between the LED chips cannot be widened too much, and the thickness of the light-shielding frame have to be reduced. In addition, if a light-shielding frame is provided for all the LED chips, the size of components will become increased. Microfabrication is required for the preparation of a thin light-shielding frame. In particular, if the size of a light-shielding frame is increased, the preparation becomes more difficult, and the production cost may be increased due to a decrease in the yield and an increase in the production time.

For example, as shown in Fig. 14, light leakage is likely to occur in LED chips 70 arranged in the center part on the substrate and forming a hot zone. The luminance when turned on is relatively high in such LED chips 70. Meanwhile, LED chips 92 whose luminance when turned on is relatively low are arranged around the LED chips 70. A light-shielding frame 94 is mainly provided between an LED chip 70 and an LED chip 92 adjacent to the LED chip 70. With this, light leakage from the LED chips 70 can be prevented, and the light-shielding frame 94 used for the entire light-emitting module can be simplified and reduced in size, thus realizing a cost reduction.

### [Coloring of the Side Surface of Frame]

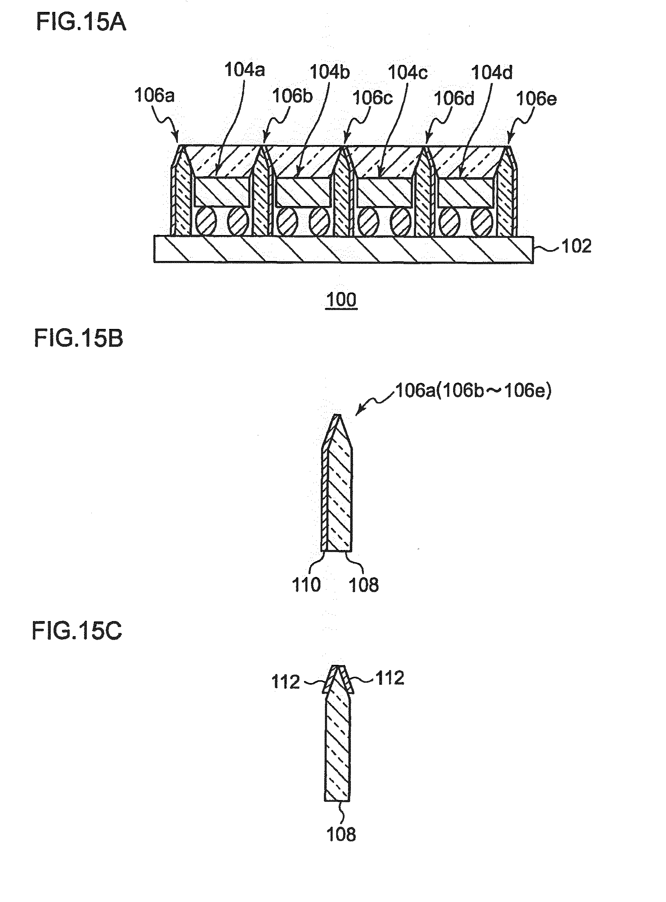

Fig. 15A is a schematic sectional view of a light-emitting module in which a light-shielding film is formed on a part of the side of a light-shielding frame, Fig. 15B is an enlarged view of a part of the light-shielding frame shown in Fig. 15A, and Fig. 15C is a view illustrating an exemplary variation of the part of the light-shielding frame shown in Fig. 15B. A light-emitting module 100 is provided with a substrate 102, flip-chip type LED chips 104a through 104d arranged on the substrate 102, and light-shielding frames 106a through 106e arranged around respective LED units.

As shown in Fig. 15B, the light-shielding frames 106a through 106e (hereinafter referred to as light-shielding frames 106) each have a body portion 108 made of a transparent material such as a glass and formed in a thin plate shape and a colored portion 110 formed on one side of the body portion 108. The material and the thickness of the colored portion 110 are not particularly limited as long as the colored portion 110 functions as a light-shielding film that shield light. With this, the width of a portion of a light-shielding frame 106 that functions as a light-shielding portion can be reduced, and the formation of a shadow in a light distribution pattern can be prevented. Alternatively, as shown in Fig. 15C, a light-shielding frame in which colored portions 112 are formed at the top of a body portion 108 may be used. The configuration of a colored portion is not particularly limited as long as the colored portion substantially functions as a light-shielding portion. For example, the colored portion needs to reflect or attenuate at least a part of light.

### [Partial Change of the Thickness of Frame]

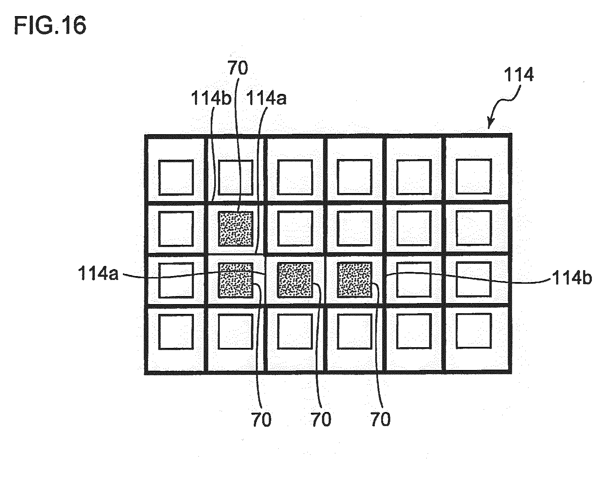

Fig. 16 is a schematic diagram illustrating a condition where the thickness of a part of a light-shielding frame is reduced. A reduction in the thickness of a light-shielding frame 114 comes with production difficulty. Accordingly, the thickness of a light-shielding frame is reduced only for a part whose thickness is particularly required to be reduced, and, for the other part, the thickness of the light-shielding frame is set to be a thickness that allows for easy production. As shown in Fig. 16, LED chips 70 forming a hot zone are arranged in the center part on the substrate. By reducing the thickness of a light-shielding frame 114a arranged in a space between LED chips 70 to be thinner than the thickness of the other part 114b, the production cost of the entire light-shielding frame 114 can be reduced.

### [Partial Change of the Size of Frame]

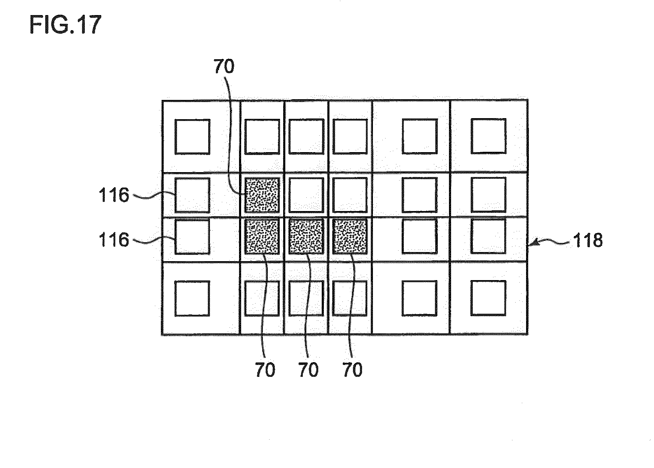

Fig. 17 is a schematic diagram illustrating a condition where the area of a region in which a light-shielding frame surrounds LED chips is changed according to a chip. As shown in Fig. 17, the area of a region surrounding one of LED chips 70 that form a hot zone is smaller than the area of a region surrounding one of LED chips 116 that surrounds the LED chips 70. In other words, a light-shielding frame 118 surrounding the LED chips 70 is configured such that the size of a plurality of partitioned regions varies by location. As a result, the LED chips 70 that form the hot zone can be arranged in a more concentrated manner, and the maximum luminance of the hot zone can be increased.

### [Light-Shielding Film]

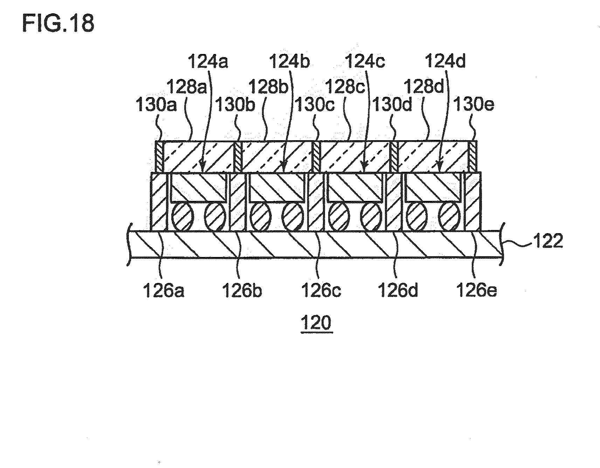

Fig. 18 is a schematic sectional view of a light-emitting module in which a light-shielding film is formed on the side of a fluorescent substance. A light-emitting module 120 is provided with a substrate 122, flip-chip type LED chips 124a through 124d arranged on the substrate 122, light-shielding frames 126a through 126e arranged around respective LED units, and fluorescent substance layers 128a through 128d provided above the respective LED units.

Light-shielding films 130a through 130e are formed on the respective side surfaces of the fluorescent substance layers 128a through 128d. The light-shielding films 130a through 130e are formed by, for example, a metal or an alloy. In the light-emitting module 120, light-shielding portions are formed by the light-shielding frames 126a through 126e and the light-shielding films 130a through 130e. With this, the shape of a light-shielding frame can be simplified.

### [Light-Shielding Frame in which Reflective Film is Formed]

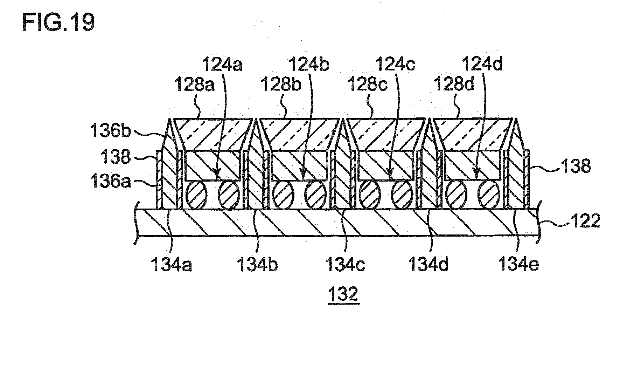

Fig. 19 is a schematic diagram illustrating a condition where a reflective film is formed on a part of a light-shielding frame. In a light-emitting module 132, light-shielding frames 134a through 134e are provided between the LED chips 124a through 124d and between the fluorescent substance layers 128a through 128d. The light-shielding frames 134a through 134e (hereinafter referred to as light-shielding frames 134) have vertical portions 136a adjacent to the respective sides of the LED chips 124a through 124d and taper portions 136b that are located above the respective vertical portions 136a and that are adjacent to the respective sides of the fluorescent substance layers 128a through 128d.

In general, luminance that can be achieved by a light-emitting module can be increased by forming reflective films on all the light-shielding frames 134. However, if reflective films are formed on the taper portions 136b, fluorescence from the fluorescent substance layers 128a through 128d are mainly reflected, causing unevenness in color. Thus, in the light-emitting module 132, reflective films are not formed on the taper portions 136b (fluorescent substance layer portions), and reflective films 138 are formed only on the respective sides of the vertical portions 136a. With this, a light-emitting module with less unevenness in color can be realized.

### [Ultraviolet light-Emitting Chip]

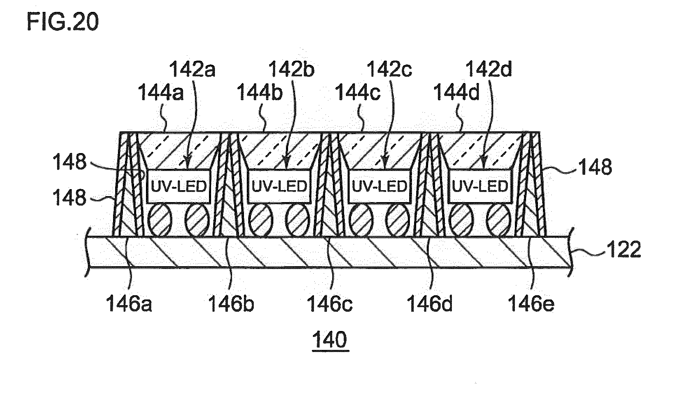

Fig. 20 is a schematic sectional view of a light-emitting module in which an ultraviolet light-emitting chip is used as an LED chip. A white LED is usually formed with a blue light-emitting LED chip and a yellow fluorescent substance. In this configuration, blue transmitted light is likely to be split, and unevenness in color is likely to be caused. Thus, as shown in Fig. 20, a light-emitting module 140 is provided with LED chips 142a through 142d that emit ultraviolet light and fluorescent substance layers 144a through 144d provided such that the fluorescent substance layers 144a through 144d face respective light-emitting surfaces of the LED chips 142a through 142d. The fluorescent substance layers 144a through 144d include blue fluorescent substances that are excited by ultraviolet light to emit blue light and yellow fluorescent substances that are excited by ultraviolet light to emit yellow light. Light-shielding frames 146a through 146e are provided between the LED chips 142a through 142d and between the fluorescent substance layers 144a through 144d.

In the light-emitting module 140, chips of an ultraviolet light-emitting type are used as LED chips, and unevenness in color is thus not likely to be caused. Therefore, reflective films 148 can be formed on the entire side surfaces of the light-shielding frames 146a through 146e, and the configuration is more simple compared to a case when reflective films are formed only on a part of the side surfaces of the light-shielding frames. Thus, the production of the light-shielding frames is facilitated.

### [Shape of Regions Partitioned by Frame]

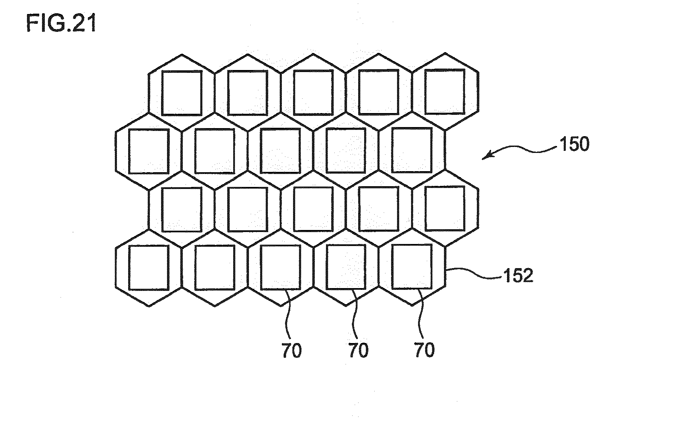

Fig. 21 is a schematic diagram illustrating a light-emitting module in which the shape of a region partitioned by a frame is hexagonal. As shown in Fig. 21, in a light-shielding frame 152 provided in a light-emitting module 150, the shape of a region that surrounds one of LED chips 70 is hexagonal. If the shape of a partition of the light-shielding frame is square, a shadow is projected onto a light distribution pattern in the longitudinal direction (vertical direction) and the traverse direction (horizontal direction). On the other hand, if the shape of a partition of the light-shielding frame is hexagonal, a shadow is projected onto a light distribution pattern in the directions other than in the longitudinal direction (vertical direction), the traverse direction (horizontal direction). Therefore, a shadow created in a light distribution pattern becomes less noticeable. The shape of the region partitioned by the frame may be polygonal such as octagonal or pentagonal.

### (3: Fluorescent Substance Layer)

### [Material of Fluorescent Substance (Phosphor)]

The composition of a fluorescent substance layer is not particularly limited as long as the fluorescent substance layer can be applied to the a variety of light-emitting modules that have been described previously. For example, the composition includes a resin composition or a glass composition with dispersed fluorescent substances and a fluorescent ceramic. In the following, some preferred modes are exemplified as the composition of a fluorescent substance.

Mixing of blue light and yellow light or mixing of red light, blue light, and green light is important in order to reduce unevenness in brightness and color among white LED chips. To achieve this, it is preferred to uniformly diffuse (disperse) fluorescent substances (phosphors) in a fluorescent substance layer. Examples include the following composition.
(A) The particle size (median diameter) of a powdered fluorescent substance is set to be 20 µm or below.
(B) A UV-excited fluorescent substance is used.
(C) Silica or alumina particles are added to the fluorescent substance layer as diffusion agents.
(D) Foams (voids) are put as diffusion agents.
(E) An YAP (perovskite phase) is mixed in a YAG (garnet layer).

### [Size of Fluorescent Substance Layer]

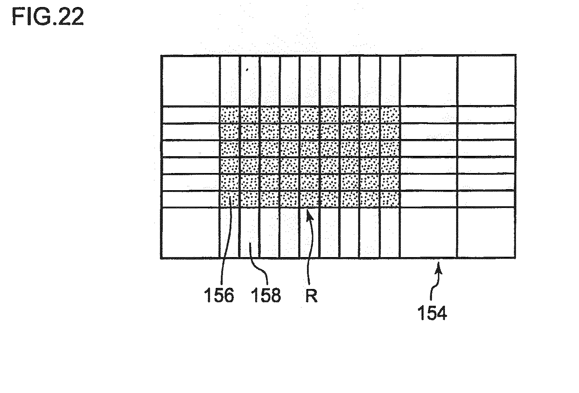

Fig. 22 is a schematic diagram illustrating a condition where the size of a fluorescent substance layer that is partitioned varies by location. In a fluorescent substance layer 154, the size of a single section 156 in a region R (dotted region) facing LED chips that form a hot zone is set to be smaller than the size of a section 158 in the other region. With this, the luminance of the hot zone in a light distribution pattern formed by a light-emitting module can be increased.

### [Shape of Fluorescent Substance Layer]

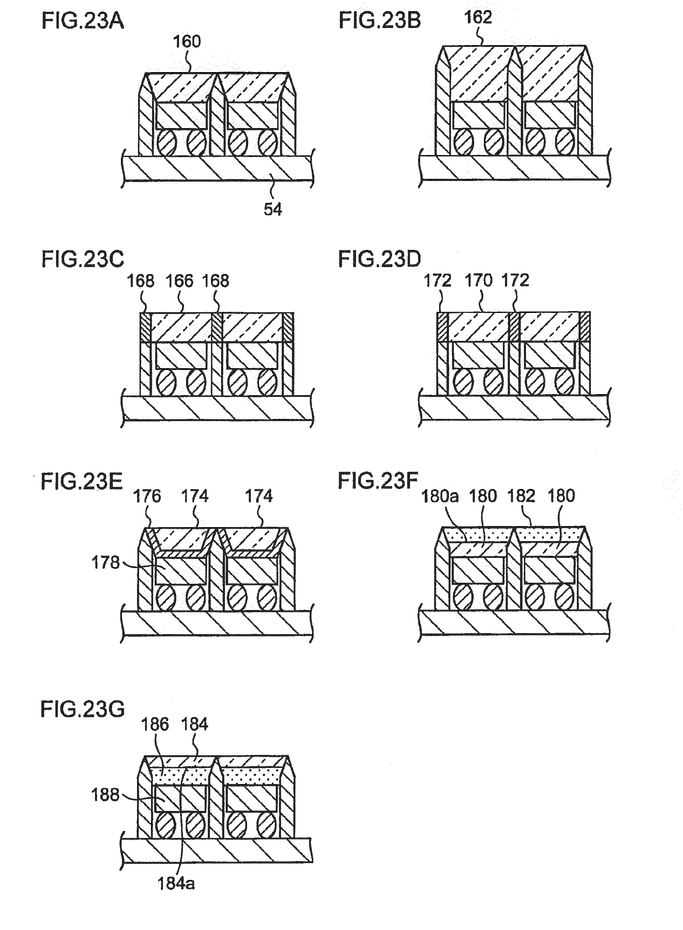

Figs. 23A to 23G are schematic sectional views for explaining the shape of a fluorescent substance layer. In a light-emitting module shown in each figure, a fluorescent substance layer is formed within a light-shielding frame for shielding light. In the production of a fluorescent substance layer, highly-accurate process control of the shape and dimension is important. Therefore, the fluorescent substance layer is preferably a plate-like fluorescent substance. With this, the processing of a fluorescent substance is facilitated. In particular, various sorts of surface processing (e.g., formation of concavities and convexities) for improving the brightness becomes possible.

A fluorescent substance layer 160 shown in Fig. 23A has a trapezoidal shape. A fluorescent substance layer 162 shown in Fig. 23B has a Y shape. On the side surfaces of a fluorescent substance layer 166 shown in Fig. 23C, reflective portions 168 are formed. On the side surfaces of a fluorescent substance layer 170 shown in Fig. 23d, light-shielding portions 172 are formed. A fluorescent substance layer 174 shown in Fig. 23E has a trapezoidal shape, and a wavelength-selective filter 176 is formed on the side surface and the bottom surface of the fluorescent substance layer 174. Therefore, in light emitted from an LED chip 178, light of a wavelength selected by the wavelength-selective filter 176 reaches the fluorescent substance layer 174.

In a fluorescent substance layer 180 shown in Fig. 23F, a light diffusion phase 182 is provided above an emission surface 180a. This allows for a reduction in unevenness in the brightness of light emitted from the fluorescent substance layer 180. In a fluorescent substance layer 184 shown in Fig. 23G, a light diffusion phase 186 is provided below an incident surface 184a. With this, unevenness in the brightness of light emitted from an LED chip 188 is reduced by the light diffusion phase 186, and the light then enters the fluorescent substance layer 184. The light diffusion phase and the fluorescent substance layer are preferably connected without using an adhesive by a method such as thermal compression bonding, normal temperature bonding, or the like. Thereby, scattering and attenuation of light when the light passes through an adhesive layer can be prevented, and an efficiency of extracting light from the entire light-emitting module is thus improved.

### [Arrangement of Fluorescent Substance Layer]

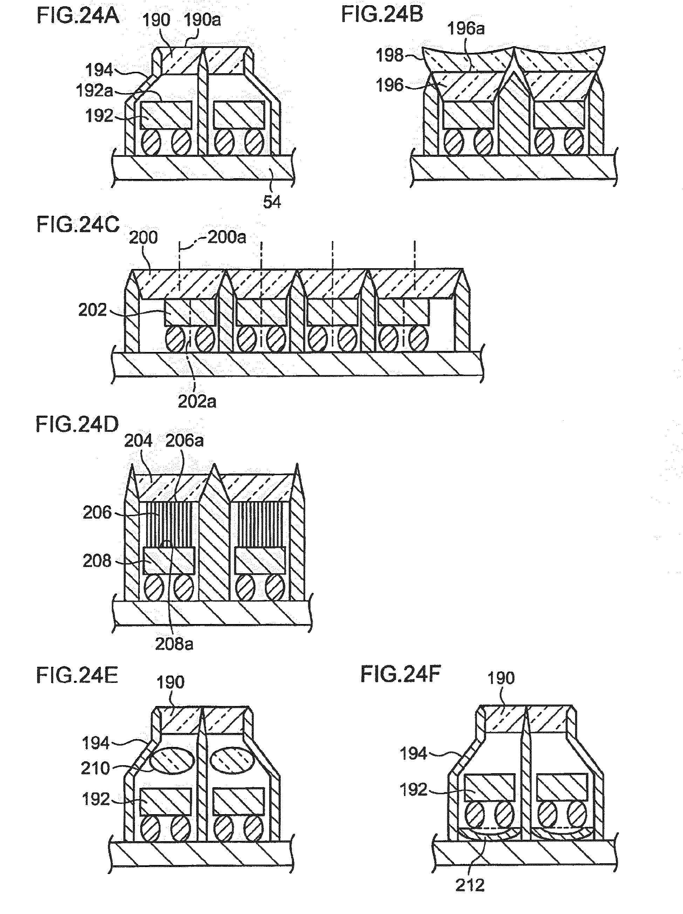

Figs. 24A to 24F are schematic sectional views for explaining the arrangement of a fluorescent substance layer in a light-emitting module. Since a fluorescent substance layer is separated from an LED chip or combined with a lens, a light-guiding plate, a reflecting mirror, or the like in consideration of the improvement in the brightness and the prevention of unevenness in color, the fluorescent substance can have various arrangements.

A fluorescent substance layer 190 shown in Fig. 24A is arranged at a position spaced apart from an LED chip 192. With this, the heat dissipation of the LED chip 192 or the fluorescent substance layer 190 is improved, and the properties of the entire light-emitting module are improved. The fluorescent substance layer 190 is surrounded by a light-shielding frame 194 and has an emission surface 190a, whose area is smaller that that of a light-emitting surface 192a of the LED chip 192. With this, the brightness of the light-emitting module is improved.

In a fluorescent substance layer 196 shown in Fig. 24B, a lens 198 is provided in front of an emission surface 196a. With this, light emitted from the fluorescent substance layer 196 can be collected. A fluorescent substance layer 200 shown in Fig. 24C is provided such that the center 200a thereof is not aligned with the center 202a of an LED chip 202.

A fluorescent substance layer 204 shown in Fig. 24D is arranged above an emission surface 206a of a light-guiding plate 206. An incident surface 206b of the light-guiding plate faces a light-emitting surface 208a of an LED chip 208. As described, light emitted by the LED chip 208 enters the fluorescent substance layer 204 after passing through the light-guiding plate 206, and a range irradiated by the light is thereby controlled. With this, light leakage among a plurality of LED chips can be prevented.

The light-guiding plate 206 has a translucent (transparent) material that allows for the penetration of light emitted by an LED chip. Examples of the translucent material include, for example, an organic material such as a transparent resin material or the like, an inorganic material such as a transparent inorganic glass or the like, a mixture of an organic material and an inorganic material, a sol-gel material, and the like. For example, examples of the resin material include an acrylic resin, a polycarbonate resin, an epoxy resin, and the like.

A light-emitting module shown in Fig. 24E is characterized in that a lens 210 is arranged between a fluorescent substance layer 190 and an LED chip 192. With this, light emitted by the LED chip 192 is collected by the lens 210 and then enters the fluorescent substance layer 190. A light-emitting module shown in Fig. 24F is characterized in that light heading beneath the LED chip 192 is collected using a reflecting mirror 212 and then directed toward the fluorescent substance layer 190.

### [Method for Forming Fluorescent Substance Layer]

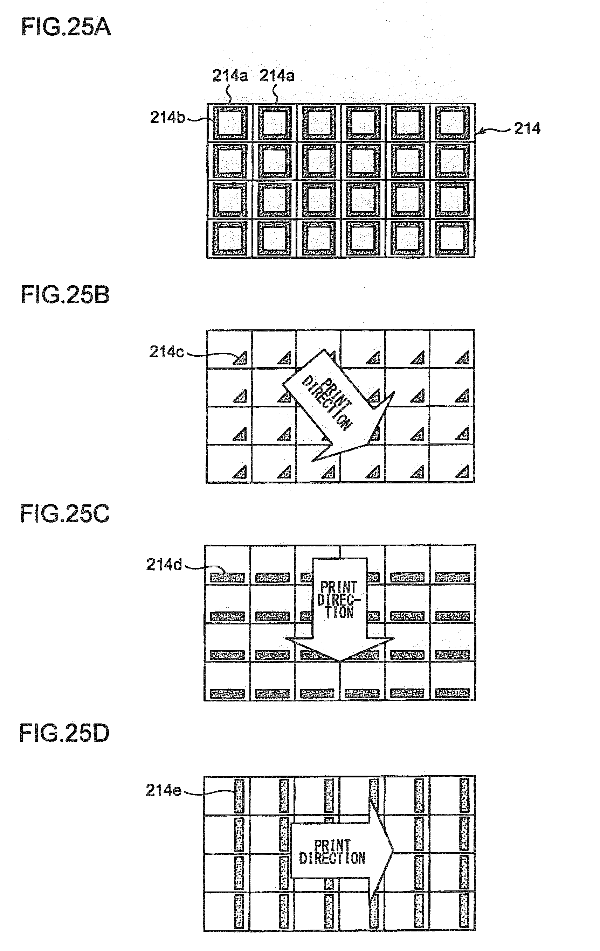

Fig. 25A is a schematic diagram illustrating a condition where a fluorescent substance layer is created for each section by a potting method, and Figs. 25B to 25D are schematic diagrams illustrating a condition where fluorescent substance layers are created all at once by a printing method. Fig. 25B shows a case when printing is performed in a printing direction that is along the direction of a diagonal line of each section corresponding to an LED chip. Fig. 25C shows a case when printing is performed in a printing direction that is along the longitudinal sides of each section corresponding to an LED chip. Fig. 25D shows a case when printing is performed in a printing direction that is along the traverse sides of each section corresponding to an LED chip.

As shown in Fig. 25A, in a fluorescent substance layer 214, a plurality of fluorescent substances 214a, which are partitioned to correspond to respective LED chips, are arranged in a matrix. When the fluorescent substance layer 214 is formed on a section-by-section basis by a potting method, a rectangular unevenness 214b is formed inside each side of a section and is visually noticeable.

A method for forming a fluorescent substance layer includes a forming method of mixing a powder fluorescent substance with a resin to make a paste and then shaping the paste into a layer by printing. As shown in Figs. 25B through 25D, by aligning a printing direction in a single direction, color unevennesses 214c through 214e can be controlled in a given direction.

### (4: Mounting Substrate)

### [Linear Expansion Coefficient]

A light-emitting module is equipped with many LED chips on a single mounting substrate. In order not to create cracks on the mounting substrate during a thermal cycle test of the light-emitting module, the linear expansion coefficient of the mounting substrate is defined to be within a range of ± 5 ppm/°C of the thermal expansion coefficient of the LED chips. With this, a decrease in connection reliability created by temperature changes repeated by turning on or off the LED chips can be prevented. If the LED chips are GaN, the thermal expansion coefficient thereof is about 7 ppm/°C. The main components of the mounting substrate are preferably alumina, AlN, Si, SiO₂, and the like.

### [Thermal Conductivity]

As described previously, a light-emitting module is equipped with many LED chips on a single mounting substrate. The thermal conductivity of the mounting substrate is preferably increased in a range that does not greatly affect other performance of the light-emitting module. A mounting substrate may be employed where a part of the mounting substrate on which LED chips that irradiate a region corresponding to a hot zone has higher thermal conductivity compared to the other part.

### [Engraving of Mounting Substrate]

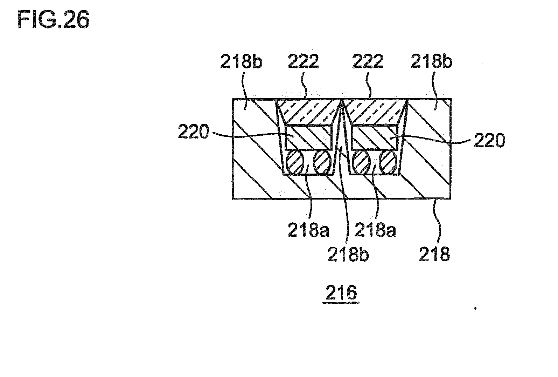

Fig. 26 is a schematic sectional view illustrating an example of a mounting substrate. A light-emitting module 216 is provided with a mounting substrate 218, LED chips 220 arranged on respective concave portions 218a of the mounting substrate 218, and a fluorescent substance layer 222 arranged above the LED chips. The concave portions 218a are formed by engraving the mounting substrate 218. Therefore, a light-shielding portion 218b is formed at the same time such that the light-shielding portion 218b surrounds the concave portions 218a. As described above, by forming the concave portions 218a by engraving the mounting substrate 218, the arrangement of a light-shielding frame on the substrate as a different component is no longer necessary. As a result, the man-hour for the assembly of the light-emitting module is reduced, allowing for a reduction in cost. For example, silicon can be used as a material of the mounting substrate.

### [Wiring Pattern]

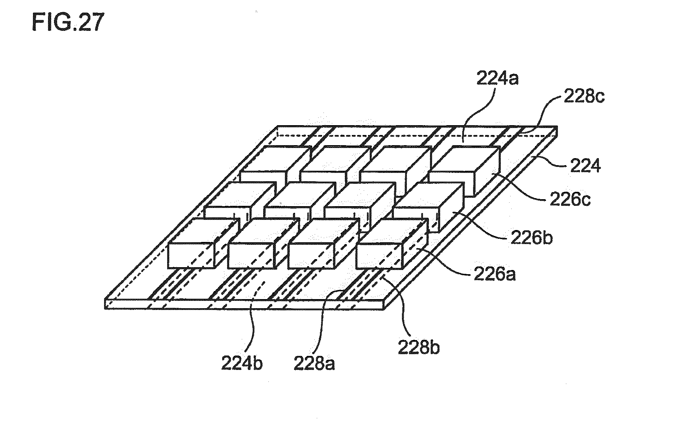

Fig. 27 is a schematic diagram illustrating a mounting substrate having a double-sided wiring. As shown in Fig. 27, a mounting substrate 224 having double-sided wiring is preferably used when there are three or more rows of LED chips. As shown in Fig. 27, a wiring 228a connected to an LED chip 226a located on a front row and a wiring 228c connected to an LED chip 226c located on a back row are formed on a front surface 224a of the mounting substrate 224. Meanwhile, a wiring 228b connected to an LED chip 226b located on a middle row is formed on a back surface 224b of the mounting substrate 224. With this, the area of the substrate can be reduced.

### [Reflective Portion]

Stray light is preferably prevented by allowing the above-stated reflective portions to have color that absorbs light (such as black), except for a light reflective surface above the light-emitting surface of an LED chip.

### (5: Lens)

### [Lens Connection Method]

As shown in Fig. 24B, there is a case where a lens is connected to a fluorescent substrate layer. Also, the lens may be connected to an LED chip. Such a lens may project a light-source image, which is created by light emitted from the LED chip and the fluorescent substance layer, on a virtual vertical screen provided in front in an irradiation direction. In this case, the connection is preferably achieved without using an organic adhesive material. This is because the probability of scattering and bending at an interface between layers is increased if the number of unnecessary layer is increased. Thus, the lens and the fluorescent substance layer or the like are connected without any adhesives by a various methods such as normal temperature bonding, interfacial activation bonding, anodic bonding, and the like. With this, light from the LED chip or light passed through the fluorescent substance layer becomes less likely to be absorbed or reflected at an interface with the lens, and luminous flux emitted from the light-emitting module is improved.

### [Anodic Bonding]

If a substrate or a light-shielding frame is made of silicon and a glass used for a lens contains an alkali metal, the substrate or the light-shielding frame can be anodically bonded (anodic bonding is a technique for achieving bonding by applying heat of about 500°C and a voltage of about 500 V to diffuse an alkali metal in a glass in silicon) with the lens. With this, hermetic sealing of the light-emitting module is possible.

### [Linear Expansion Coefficient]

When performing the above-stated anodic bonding, the linear expansion coefficient of the glass is preferably set to be close to 3 ppm/°C, which is the linear expansion coefficient of silicon. More specifically, the glass used for the lens is preferably a material whose linear expansion coefficient is in a range of 1 to 10 ppm/°C.

### [Lens Array]

A lens array may be mounted on the above-stated light-emitting module in which LED chips are arranged in an array (in a matrix). A lens array is designed such that a plurality of lenses corresponding to respective LED chips are formed on a single plate-like member. Such a lens array is disclosed in, for example, PCT Japanese Translation Patent Publication No. 2006-520518. Since a light-emitting module according to the embodiment of the present invention is provided with a light-shielding portion, light leakage can be prevented even when such a lens array is used. Also, a reduction of cost may be achieved by making the lens array by integral molding by a resin.

### [CPC Lens]

As a type of the lens array, a CPC lens may be used. With this, an color unevenness in an individual light-emitting unit can be overcome.

### [Lens Shading]

A lens may be shaded only in the longitudinal direction. If a dark part created between light-emitting units (a single LED chip and a single fluorescent substance) is projected in the longitudinal direction as a black line when an LED array is all turned on, the projection lens 24 (PES lens) shown in Fig. 1 or the like, which is the last lens that emits light, may be shaded in the longitudinal direction.

Alternatively, the lens may be shaded only in the traverse direction. If a dark part created between light-emitting units is projected in the traverse direction as a black line when the LED array is all turned on, the projection lens 24 shown in Fig. 1 may be shaded in the traverse direction.

Alternatively, the lens may be shaded only in the oblique direction. If a dark part created between light-emitting units is projected in the oblique direction as a black line when the LED array is all turned on, the projection lens 24 shown in Fig. 1 may be shaded in the oblique direction. Shading in the longitudinal direction, in the traverse direction, and in the oblique direction may be appropriately combined.

### [Optical Fiber Array]

A brightness unevenness and a color unevenness may be reduced by using an optical fiber array. By providing a light-guiding plate layer in which optical fibers are put into a bundle on an LED chip or on a fluorescent substance layer, a brightness unevenness and a color unevenness can be reduced.

### [Flat-plate Microlens]

A flat-plate microlens may be provided. An optical lens may be formed by distributing components having a high or low refractive index in a plate-like transparent body (GRIN lens).

### [Space Filling]

In the automotive lamp 10 shown in Fig. 1, light emitted from the LED chip 22a passes through an air layer before the light reaches the projection lens 24. Therefore, there is room for the improvement in an efficiency of extracting luminous flux due to interfacial reflection. Thus, a configuration is preferred in which such an air layer does not lie therebetween. For example, a space between the projection lens 24 and the light-emitting module 22 is preferably filled with a silicone gel.

As described, if a space between a lens and a light-emitting module is filled with gel such that the lens and the light-emitting module are optically connected but are not mechanically bonded (closely adhered), the light-emitting module can be applied to an automotive lamp (headlamp) of a different design.

### [Fluorescent Substance Lens]

A fluorescent substance may be processed into a lens shape and may be mounted on an LED chip so as to form a light-emitting module. Since the fluorescent substance has a convex lens shape, there is no trapping of light due to a critical angle. Thus, luminous flux is improved for the light-emitting module as a whole.

### (6: Control Circuit)

### [Power Saving When Vehicle is Stopped]

When a vehicle is being stopped at a traffic light or the like, the vehicle does not need to light a road surface; however the vehicle needs to turn the light on so that other vehicles can notice the vehicle. In a vehicle that uses a conventional bulb-type light source, there is a problem where the life of a bulb is shortened if a headlight is turned off when the vehicle is stopped. However, in a light-emitting module according to the embodiment of the present invention, an LED is used as a light source, and there is thus less effect on the life of the light source by the turning off of the light. In order to achieve both safety and power saving, it is possible to set a power-saving mode, in which an electric current is lowered or blocked, when the vehicle is stopped.

The automotive lamp 10 shown in Fig. 1 is provided with a light-emitting module 22 and a control circuit (not shown) that controls the turning on and off of the light-emitting module 22. If the control circuit detects a condition where a vehicle provided with the automotive lamp is stopped, the control circuit controls the turned-on or turned-off condition of the light-emitting module so as to enter a vehicle stop mode where the power consumption is smaller than that during an irradiation mode used when the vehicle is running. This allows for the power saving of an automotive lamp without requiring an operation by a driver.

### [Addition of Communication Function]

The above-stated control circuit is capable of performing turning-on and turning-off control of an LED of a light-emitting module. Since the speed of the turning on and off of the LED is fast, information can be transmitted by pulse lighting. Thus, the control circuit be provided with a function of controlling communication between vehicles (the driver's own car and another car) and between a road and a vehicle (traffic light and vehicle or the like) in addition to a function for turning-on and turning-off control for ADB (Adaptive Driving Beam).

### [Flash at the time of the Collision]

In recent years, drive recorders have been increasingly mounted mainly in commercial vehicles. However, the performance of an image-capturing means such as a camera or the like that is mounted is often low, and images are often unclear due to insufficient light intensity particularly at night time. Thus, the control circuit of the automotive lamp 10 increases the light intensity of the light-emitting module 22 if the control circuit detects the moment of collision based on information from a detection means that detects the moment of the collision. With this, accidents can be clearly recorded by the image-capturing means provided in the vehicle.

### [Control at the time of the Tuning On and Off]

In the case of light-distribution control by ADB in the automotive lamp 10, when another vehicle emerges, glare is casted onto the vehicle unless an LED chip that is irradiating a region, in which the vehicle exists, is instantly turned off. On the other hand, a feeling of strangeness is provided to the driver when the LED chip, which has been turned off, is turned on at the moment said another vehicle is gone. Thus, when turning on an LED chip that has been turned off, the control circuit controls an electric current (voltage) to the LED chip such that the light intensity gradually increases.

### [Spotlight]

A main purpose of the light-distribution control by ADB is to partially turn off some of a plurality of LED chips in order for the prevention of glare. However, when a pedestrian or the like is detected, the control circuit may perform control of increasing, in a spotted manner, the light intensity of an LED chip that irradiates a region in which the pedestrian exists in order to alert the driver.

### [Exemplary Embodiment]

A description is further given in detail regarding a light-emitting module by using exemplary embodiments and comparative examples in the following. First, four blue LED chips of a size of 1 × 1 mm and of a light-emission peak wavelength of 450 nm are mounted on a mounting substrate made of aluminum nitride that is wired such that light modulation could be performed for each individual LED. Then, a light-shielding frame obtained by performing microfabrication on silicon is mounted, and a fluorescent substance layer is implemented so as to prepare an LED package (hereinafter, referred to as "light-emitting module").

This light-emitting module is placed on a heat sink made of die-cast aluminum and is stabilized for ten minutes while applying an electric current of 700 mA to the four LED chips. The brightness is measured by a two-dimensional color luminance meter CA1500 manufactured by Konica Minolta from the front surface (the upper surface of the light-emitting module) of a light-emitting surface of the light-emitting module so as to measure a brightness distribution in the longitudinal direction of the light-emitting module. The longitudinal direction is a direction in which the approximate centers of respective light-emitting surfaces of the LED chips are connected.

The electric current of one LED chip is then blocked, and a brightness distribution is measured. Further, the brightness of a turned-off portion is measured. The light-emitting module, in which the brightness of the turned-off portion is low enough to allow for the shielding of light, is placed in a lamp provided with a plano-convex lens of ϕ60 with a focal length of 40 mm. The light-emitting module is turned on and projected to a screen that is located 25 m ahead, and a luminance distribution is measured. Then, in the same way as in the brightness measurement, the electric current of one LED is blocked, and a luminance distribution is measured again. In order not to cast glare onto oncoming vehicles, leading vehicles, and pedestrians, it is necessary to keep the luminance of a region corresponding to the turned-off LED chip to be 625 cd or below.

### (Comparative Example 1)

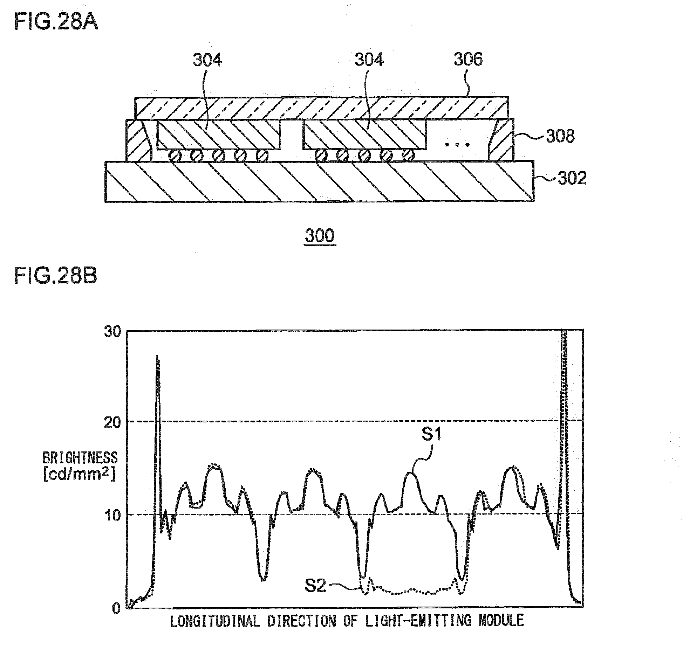

Fig. 28A is a schematic sectional view of a light-emitting module according to comparative example 1, and Fig. 28B is a view illustrating a graph of a brightness distribution of the light-emitting module according to comparative example 1. In Fig. 28B, a curve S1 represents a brightness distribution when all the four LEDs are turned on, and a curve S2 represents a brightness distribution when only one LED is turned off. The same applies to a brightness distribution in the following exemplary embodiments.

A light-emitting module 300 according to a comparative example 1 is provided with a substrate 302, a plurality of LED chips 304 mounted on the substrate 302, a fluorescent substance layer 306 composed of a single YAG sintered compact of a size that covers the plurality of LED chips 304, and an outer frame 308, which is held by the substrate 302 and which supports the periphery of the fluorescent substance layer 306.

In the light-emitting module 300, neither an individual LED chip 304 nor the fluorescent substance layer 306 has a structure (configuration) for optically separating (shielding light) adjacent light-emitting portions (light-emitting surfaces). Therefore, even when one LED chip is turned off, the brightness of the portion is 1.5 cd/mm² (the lowest part of a curve S2 shown in Fig. 28B), and light shielding is thus not sufficient.

### (Exemplary Embodiment 1)

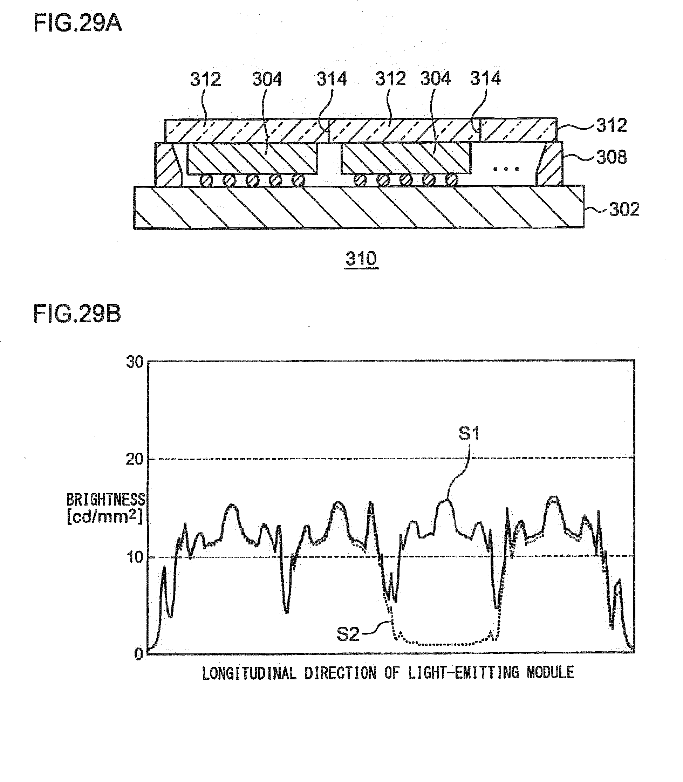

Fig. 29A is a schematic sectional view of a light-emitting module according to exemplary embodiment 1, and Fig. 29B is a view illustrating a graph of a brightness distribution of the light-emitting module according to exemplary embodiment 1. In the light-emitting module according to exemplary embodiment 1, like numerals represent like constituting elements in the comparative example 1, and the description thereof is appropriately omitted.

In a light-emitting module 310, no light-shielding structure is placed between LED chips 304. Meanwhile, each fluorescent substance layer 312 is composed of a YAG sintered compact of a size that covers a single LED chip 304, and a silver paste 314 is applied to the side surfaces thereof. With this, light emitted from an adjacent fluorescent substance layer 312 is shielded. As a result, when one LED chip is turned off, the brightness of the portion is greatly reduced to be 0.3 cd/mm² (the lowest part of a curve S2 shown in Fig. 29B), showing a light-shielding effect.

### (Exemplary Embodiment 2)

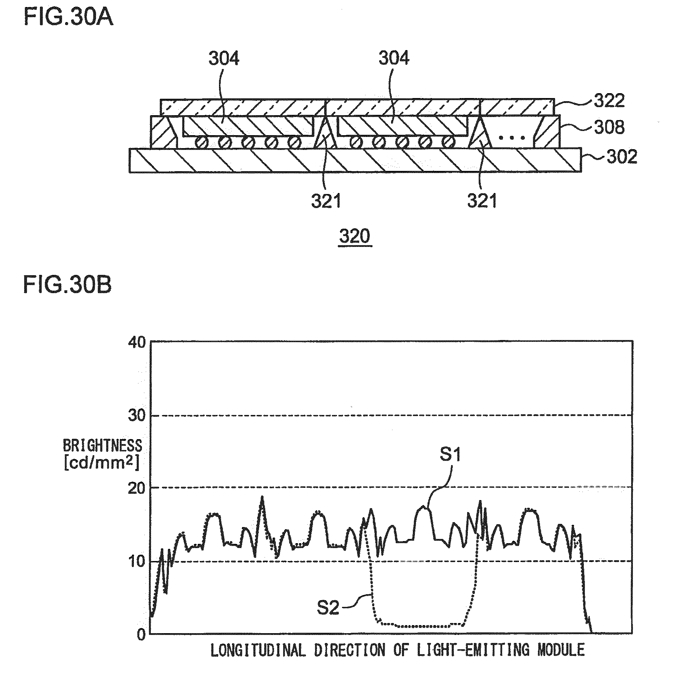

Fig. 30A is a schematic sectional view of a light-emitting module according to exemplary embodiment 2, and Fig. 30B is a view illustrating a graph of a brightness distribution of the light-emitting module according to exemplary embodiment 2. In the light-emitting module according to exemplary embodiment 2, like numerals represent like constituting elements described previously, and the description thereof is appropriately omitted.

In a light-emitting module 320, a triangle frame 321 obtained by performing microfabrication on silicon is placed between LED chips 304 so as to shield light. With this, light emitted from an adjacent LED chip 304 is shielded. Meanwhile, a fluorescent substance layer 322 is composed of a YAG sintered compact of a size covering a single LED chip 304, and nothing is applied to the side surfaces thereof. As a result, when one LED chip is turned off, the brightness of the portion is greatly reduced to be 0.6 cd/mm² (the lowest part of a curve S2 shown in Fig. 30B), showing a light-shielding effect.

The light-emitting module 320 is integrated in a lamp, and a luminance distribution is measured. The minimum luminance when one LED chip is turned off is 500 cd, and it is found that the luminance is below a luminance of 625 cd at which glare might be casted onto oncoming vehicles, leading vehicles, and pedestrians. As a result of the exemplary embodiment 2, it is found that, as long as the brightness of a turned-off portion of the light-emitting module is 0.6 cd/mm² or below, the production of glare when applied to a lamp can be prevented.

### (Exemplary Embodiment 3)

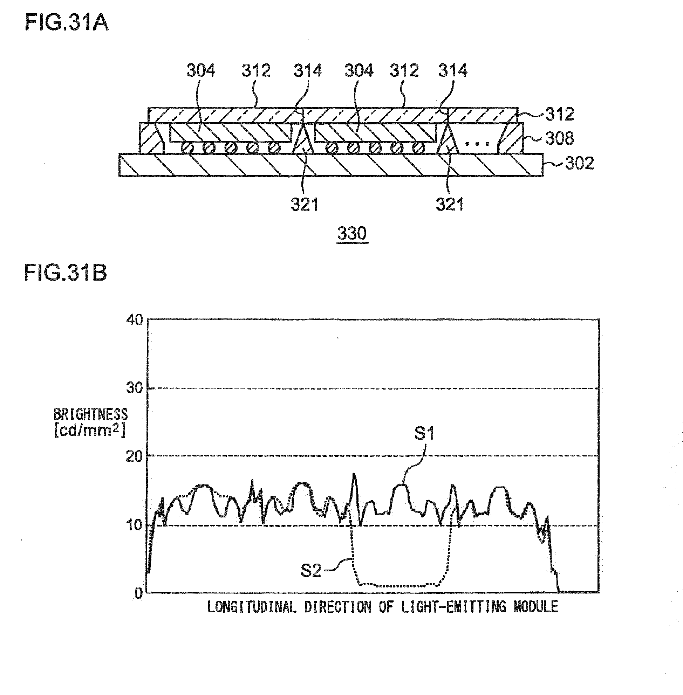

Fig. 31A is a schematic sectional view of a light-emitting module according to exemplary embodiment 3, and Fig. 31B is a view illustrating a graph of a brightness distribution of the light-emitting module according to exemplary embodiment 3. In the light-emitting module according to exemplary embodiment 3, like numerals represent like constituting elements described previously, and the description thereof is appropriately omitted.

In a light-emitting module 330, a triangle frame 321 obtained by performing microfabrication on silicon is placed between LED chips 304 so as to shield light. With this, light emitted from an adjacent LED chip 304 is shielded. Meanwhile, each fluorescent substance layer 312 is composed of a YAG sintered compact of a size that covers a single LED chip 304, and a silver paste 314 is applied to the side surfaces thereof. With this, light emitted from an adjacent fluorescent substance layer 312 is shielded. As described, by optically separating the LED chips and the fluorescent substance layers, when one LED chip is turned off, the brightness of the portion is greatly reduced to be 0.3 cd/mm² (the lowest part of a curve S2 shown in Fig. 31B), showing a light-shielding effect.

### (Exemplary Embodiment 4)

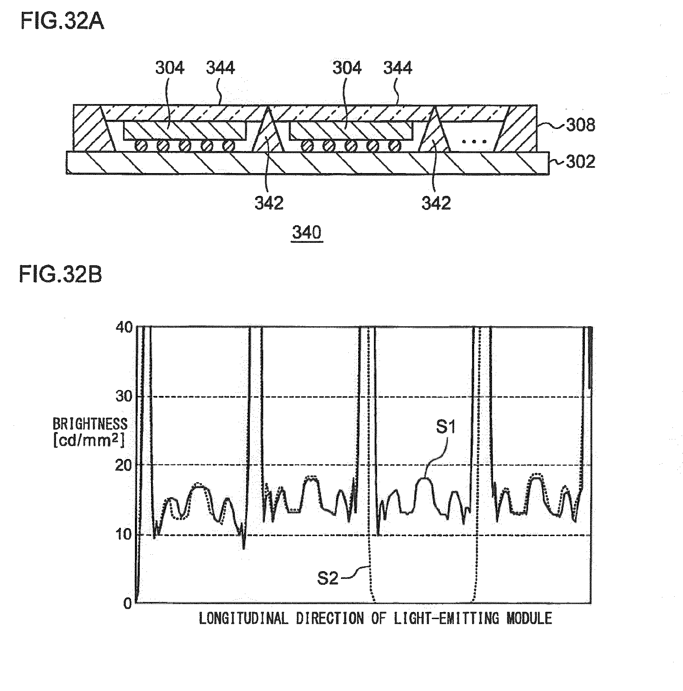

Fig. 32A is a schematic sectional view of a light-emitting module according to exemplary embodiment 4, and Fig. 32B is a view illustrating a graph of a brightness distribution of the light-emitting module according to exemplary embodiment 4. In the light-emitting module according to exemplary embodiment 4, like numerals represent like constituting elements described previously, and the description thereof is appropriately omitted.

In a light-emitting module 340, a triangle frame 342 obtained by performing microfabrication on silicon is placed between LED chips 304 so as to shield light. With this, light emitted from an adjacent LED chip 304 is shielded. The apex of the triangle frame 342 is located near the front surface of a fluorescent substance layer 344. Each fluorescent substance layer 344 is composed of a YAG sintered compact of a size covering a single LED chip 304. With this, light emitted from an adjacent fluorescent substance layer 344 is shielded. As described, by optically separating the LED chips and the fluorescent substance layers, when one LED chip is turned off, the brightness of the portion is greatly reduced to be 0 cd/mm² (the lowest part of a curve S2 shown in Fig. 32B), showing a light-shielding effect.

The light-emitting module 340 is integrated in a lamp, and a luminance distribution is measured. The minimum luminance when one LED chip is turned off is 300 cd, and it is confirmed that the luminance is below a luminance of 625 cd at which glare might be casted onto oncoming vehicles, leading vehicles, and pedestrians.

### (Exemplary Embodiment 5)

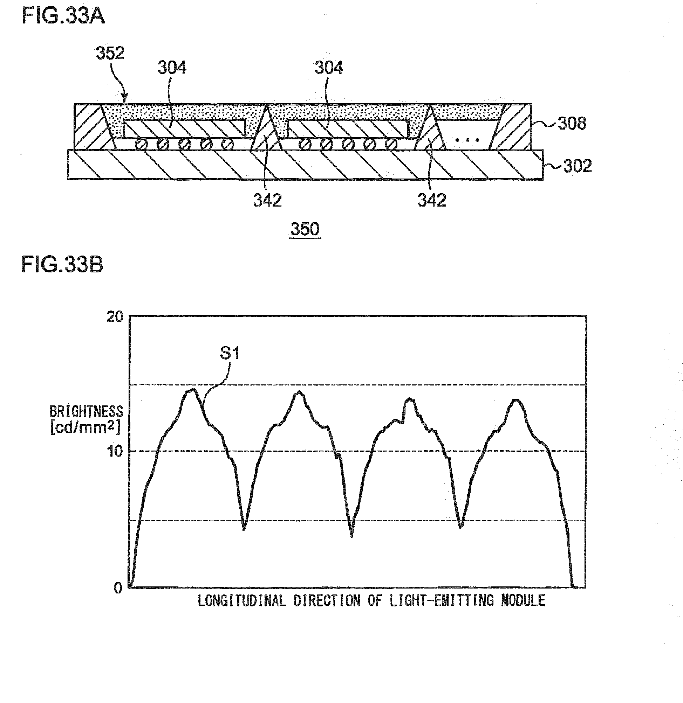

Fig. 33A is a schematic sectional view of a light-emitting module according to exemplary embodiment 5, and Fig. 33B is a view illustrating a graph of a brightness distribution of the light-emitting module according to exemplary embodiment 5. Fig. 33B shows only a brightness distribution (curve S1) when all the four LEDs are turned on. In the light-emitting module according to exemplary embodiment 5, like numerals represent like constituting elements described previously, and the description thereof is appropriately omitted.

In a light-emitting module 350, a triangle frame 342 obtained by performing microfabrication on silicon is placed between LED chips 304 so as to shield light. With this, light emitted from an adjacent LED chip 304 is shielded. The apex of the triangle frame 342 is exposed through the front surface of a fluorescent substance layer 352. The fluorescent substance layer 352 is formed by printing a paste, in which YAG powder is mixed in a dimethyl silicone resin to account for 12 volume percent, on the LED chips 304 with use of a squeegee. The tip of the triangle frame 342 is adjusted at that time such that the tip is exposed. With this, light emitted from an adjacent fluorescent substance layer 352 is shielded. As described, by optically separating the LED chips and the fluorescent substance layers, when one LED chip is turned off, the brightness of the portion is greatly reduced to be 0 cd/mm², showing a light-shielding effect.

The light-emitting module 340 is integrated in a lamp, and a luminance distribution is measured. The minimum luminance when one LED chip is turned off is 300 cd or below, and it is confirmed that the luminance is below a luminance of 625 cd at which glare might be casted onto oncoming vehicles, leading vehicles, and pedestrians.

### (Exemplary Embodiment 6)

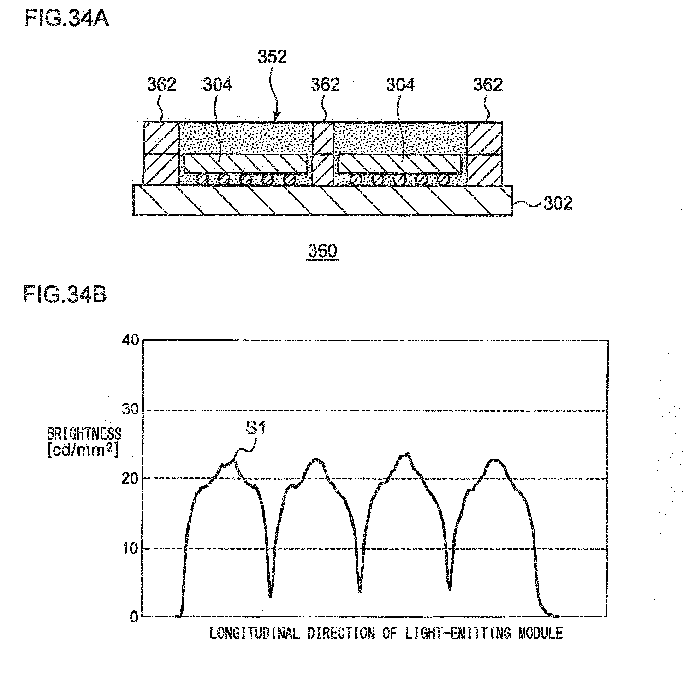

Fig. 34A is a schematic sectional view of a light-emitting module according to exemplary embodiment 6, and Fig. 34B is a view illustrating a graph of a brightness distribution of the light-emitting module according to exemplary embodiment 6. Fig. 34B shows only a brightness distribution (curve S1) when all the four LEDs are turned on. In the light-emitting module according to exemplary embodiment 6, like numerals represent like constituting elements described previously, and the description thereof is appropriately omitted.

In a light-emitting module 360, a vertical frame 362 obtained by performing microfabrication on silicon is placed between LED chips 304 so as to shield light. The vertical frame 362 is provided such that the side surfaces thereof are approximately vertical to the front surface of a substrate 302. With this, operations and effects that are similar to those according to the exemplary embodiment 5 are obtained.

### (Exemplary Embodiment 7)

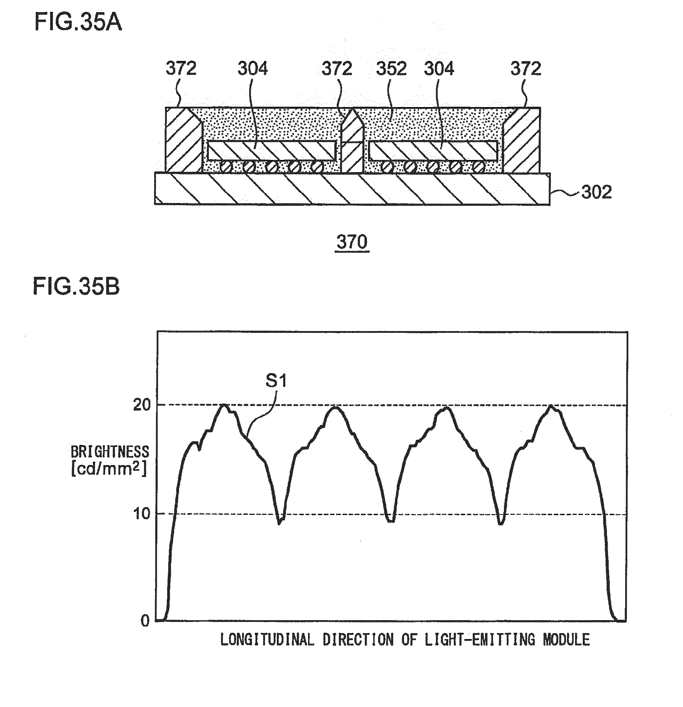

Fig. 35A is a schematic sectional view of a light-emitting module according to exemplary embodiment 7, and Fig. 35B is a view illustrating a graph of a brightness distribution of the light-emitting module according to exemplary embodiment 7. Fig. 35B shows only a brightness distribution (curve S1) when all the four LEDs are turned on. In the light-emitting module according to exemplary embodiment 7, like numerals represent like constituting elements described previously, and the description thereof is appropriately omitted.

In a light-emitting module 370, a frame 372 obtained by performing microfabrication on silicon is placed between LED chips 304 so as to shield light. The frame 372 is provided such that a side surface thereof on the side close to a substrate 302 (a lower part in Fig. 35A) is approximately vertical to the front surface of the substrate 302 and such that a side surface thereof on the side close to the front surface of a fluorescent substrate layer 352 (an upper part in Fig. 35A) is diagonal to the front surface of the substrate 302. With this, operations and effects that are similar to those according to the exemplary embodiment 5 are obtained.

### (Exemplary Embodiment 8)

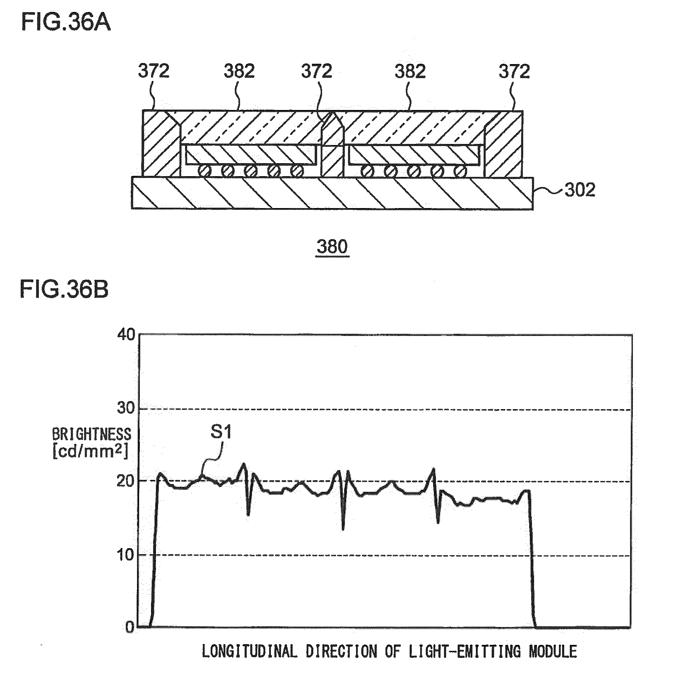

Fig. 36A is a schematic sectional view of a light-emitting module according to exemplary embodiment 8, and Fig. 36B is a view illustrating a graph of a brightness distribution of the light-emitting module according to exemplary embodiment 8. Fig. 36B shows only a brightness distribution (curve S1) when all the four LEDs are turned on. In the light-emitting module according to exemplary embodiment 8, like numerals represent like constituting elements described previously, and the description thereof is appropriately omitted.

In a light-emitting module 380, a frame 372 obtained by performing microfabrication on silicon is placed between LED chips 304 so as to shield light. A fluorescent substance layer 382 composed of a YAG sintered plate cut along the shape of the frame 372 is mounted on the LED chips 304. Preferably, when straight light having a wavelength in a fluorescent region (600 nm) enters the YAG sintered plate, the YAG sintered plate emits 40% or more of the light as diffused light.

The brightness distribution and the luminance distribution of the light-emitting module 380 thus configured are measured. There are very few dark parts (parts where the brightness is lowered) between the LED chips, and there is little change in the brightness distribution on the surfaces of the LED chips. Thus, a sense of uniformity when all the LEDs are turned on is improved remarkably.

The present invention has been described by referring to the above-described embodiments and exemplary embodiments. The present invention is not limited to the above-described embodiments or the exemplary embodiments only, and those resulting from any combination of them as appropriate or substitution are also within the scope of the present invention. Also, it is understood by those skilled in the art that various modifications such as changes in the order of combination or processing made as appropriate in each embodiment or exemplary embodiment or changes in design may be added to the embodiments or the exemplary embodiments based on their knowledge and the embodiments added with such modifications are also within the scope of the present invention.

### [DESCRIPTION OF THE REFERENCE NUMERALS]

10 automotive lamp, 12 lamp body, 14 translucent cover, 18 lamp unit, 22 light-emitting module, 22a LED chip, 24 projection lens, 50 light-emitting module, 54 substrate, 56a light-emitting surface, 58 fluorescent substrate layer, 60a light-shielding portion, 64 LED chip

### [INDUSTRIAL APPLICABILITY]

A light-emitting module according to the present invention can be used in a variety of lighting devices, e.g., lightning fixtures, displays, vehicle lights, signals, etc.

## Claims

1. A light-emitting module comprising:
a substrate;
a plurality of light-emitting elements mounted on the substrate and arranged in a matrix;
a fluorescent member provided such that the fluorescent member faces respective light-emitting surfaces of the light-emitting elements; and
a light-shielding portion provided such that the light-shielding portion surrounds the perimeter of respective light-emitting surfaces of at least some light-emitting elements among the plurality of light-emitting elements.

2. The light-emitting module according to claim 1,
wherein the plurality of light-emitting elements include a first light-emitting element having relatively high luminance when turned on and a second light-emitting element having relatively low luminance when turned on, and
wherein the light-shielding portion is mainly provided between the first light-emitting element and a light-emitting element adjacent to the first light-emitting element.

3. The light-emitting module according to claim 1 or 2, wherein the light-emitting elements are flip-chip type elements.

4. The light-emitting module according to any one of claims 1 through 3, wherein the fluorescent member is a plate-like fluorescent substance.

5. The light-emitting module according to any one of claims 1 through 4, wherein the thermal expansion coefficient of the substrate is in a range of ± 5 ppm/°C of the thermal expansion coefficient of the light-emitting elements.

6. The light-emitting module according to any one of claims 1 through 5, further comprising:
a lens configured to project a light-source image, which is created by light emitted from the light-emitting elements and the fluorescent member, on a virtual vertical screen provided in front in an irradiation direction,
wherein the lens is directly connected to the light-emitting elements or the fluorescent member.

7. An automotive lamp comprising:
the light-emitting module according to any one of claims 1 through 6; and
a control circuit configured to control the turning on and off of the light-emitting module,
wherein, if the control circuit detects a condition where a vehicle provided with the automotive lamp is stopped, the control circuit controls the turned-on or turned-off condition of the light-emitting module so as to enter a vehicle stop mode where the power consumption is smaller than that during an irradiation mode used when the vehicle is running.
